(19) Europäisches Patentamt / European Patent Office / Office européen des brevets

(11) **EP 3 848 485 A1**

(12) **EUROPEAN PATENT APPLICATION**

(43) Date of publication:
14.07.2021 Bulletin 2021/28

(21) Application number: 20020016.0

(22) Date of filing: 10.01.2020

(51) Int Cl.:
C23C 28/04 (2006.01)          C23C 16/02 (2006.01)
C23C 16/12 (2006.01)          C23C 16/14 (2006.01)
C23C 16/56 (2006.01)          C23C 30/00 (2006.01)
C23C 16/40 (2006.01)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(71) Applicant: **Ruppi, Sakari**
**8600-780 Lagos (PT)**

(72) Inventor: **Ruppi, Sakari**
**8600-780 Lagos (PT)**

Remarks:
The references to the drawing(s) no. 1-6 are deemed
to be deleted (Rule 56(4) EPC).

(54) **IMPROVED ALPHA ALUMINA LAYER DEPOSITED WITH CONTROLLED TEXTURES**

(57) The present invention relates to a coated cutting tool consisting of a substrate of cemented carbide, cermet, ceramics, steel or a superhard material such as cubic boron nitride (CBN) at least partially coated with a coating consisting of at least one outer layer of 5 to 35 $\mu$m, thick $\alpha$-$Al_2O_3$ layer deposited by chemical vapour deposition (CVD) on an inner layer of 2-25 $\mu$m thick Ti(C,N) or $TaC_{1-x}N_x$ or combinations thereof wherein the said $\alpha$-$Al_2O_3$ exhibits an X-ray diffraction pattern, as measured using $CuK_\alpha$ radiation and theta-2theta scan, and texture coefficients TC(hkl) being determined according to Harris formula with one dominant texture coefficient $4,5 < TC(hkl) < 7$, selected from the reflections (110), (300), (006), (102), (104) and (00 12). The dominating TC(hkl) being determined by $H_2S/CO_2$ ratio. The alumina layer is characterized by improved textures and by high growth rates together with improved wear resistance and toughness.

**Description**

FIELD OF THE INVENTION

The present invention relates to a cutting tool insert and the method of manufacturing the same, the cutting tool insert consisting of a substrate of cemented carbide, cermet, ceramics, steel or a superhard material such as cubic boron nitride (CBN) being at least partly coated with a coating of a total thickness of 15-65 $\mu$m consisting of one or more refractory layers comprising at least one strongly textured layer of $\alpha$-$Al_2O_3$ deposited by chemical vapour deposition (CVD) wherein the refractory layer underneath the said $\alpha$-$Al_2O_3$ layer is a layer of MT-CVD Ti(C,N) or CVD $TaC_{1-x}N_x$. The present invention further relates to a process to produce the inventive tool.

BACKGROUND OF THE INVENTION AND PRIOR ART

Today, both alpha $\alpha$-$Al_2O_3$ and $\alpha$-$Al_2O_3$ polymorphs are used as hard coatings, and they can be deposited in a controlled way by modern CVD technology shown, for example in U.S. Patents 5,137,774 and 5,700,569.

The control of the $\alpha$-$Al_2O_3$ polymorph in industrial scale was achieved in the beginning of the 1990's with commercial products based on US patent 5,137,774. Later modifications of this patent have been used to deposit $\alpha$-$Al_2O_3$ with preferred textures. In US 5,654,035 an alumina layer with the (012) texture and in US 5,980,988 an alumina layer with the (110) texture are disclosed. In US 5,863,640 the (012), (104) and (110) textures are disclosed. US 6,333,103 describes a modified method to control the nucleation and growth of $\alpha$-$Al_2O_3$ on the (10(10)) plane. US 6,869,668 describes a method to obtain a strong (100) texture in $\alpha$-$Al_2O_3$ using a texture modifying agent ($ZrCl_4$).

US 7,094,447 describes a technique to achieve a pronounced (012) texture. Enhanced deposition techniques to produce pronounced (104) and (116) textures are disclosed in US2006/0199026 and US 2006/0141271, respectively. The prior-art processes discussed above use all deposition temperatures of about 1000 °C.

US 7993742B2 and EP1953258B1/US2008187774B2 disclose (001) textured alumina layers. The (012), (104) and (001) textured alumina layers are compared and the (001) texture is found superior to the other textures. In the above-mentioned disclosures the textures of the alumina layers were determined by using XRD and quantified by texture coefficients (TC). In US 7763346B2 and EP01479B1 (US7201956) EBSD has been used to claim the (001) texture and quantified by inclination of the basal (001) plane. Despite the techniques used the (001) textured alumina coatings are claimed to be superior to other textured coatings.

However, in prior art the texture control of $\alpha$-$Al_2O_3$ has been performed by trial and error. The prior-art reveals that the important aspects of the texture control have clearly not been realized this being especially important to understand when depositing (001) textured $\alpha$-$Al_2O_3$ layers.

In a recent US patent application 2018/0274091 A1 effects of $H_2S$ on the growth and texture of $\alpha$-$Al_2O_3$ has been studied. The inventors claim that nucleation surface (oxidation treatment) is important to pre-determine the texture, however, they simultaneously emphasize that $\alpha$-$Al_2O_3$ starts to grow having (110) texture during uncatalyzed ($H_2S$ =0) growth of $\alpha$-$Al_2O_3$ independent on the nucleation surface. This is contractionary. Further, according to this application (US 2018/0274091 A1) the growth rate of $\alpha$-$Al_2O_3$ increases with increasing $H_2S$ level and reaches a plateau at 0.048 vol% of $H_2S$. This result is obtained using $CO_2$ concentration of 2.49 vol %. The $CO_2$ levels used in this application were very limed being from 2.01 to 4.87 vol %. In addition, the maximum level of $H_2S$ in this this application was only about 0.25 vol %. It is emphasized that the standard procedures used to deposit $\alpha$-$Al_2O_3$ for decades have started uncatalyzed ($H_2S$ = 0) for about 15-60 minutes, usually 30 min. As will be discussed later, this results in the formation of (110) texture, which can thus be found in all prior-art $\alpha$-$Al_2O_3$ layers next to the nucleation surface. Further, it should be noted that the process data disclosed in US 2018/0274091 A1, for example, for (001) $\alpha$-$Al_2O_3$ does not results in this texture according to the present invention, and as clear from the Examples given below.

It is important to realize that the prior-art processes for $\alpha$-$Al_2O_3$ are generally using process data giving an average growth rate of about 0.6 to about 1 $\mu$m/h, usually clearly less than about 1 $\mu$m/h at about 1000 $\underline{o}$C. There is consequently a need to enhance the deposition rate in the CVD reactor with simultaneous improvements in texture and grain size control.

Clearly, there here is also a need to enhance and understand the process control of the alumina textures and enhance productivity by increasing the deposition rate in the CVD reactor with simultaneous texture and grain-size control.

OBJECT OF THE INVENTION

It is an object of this invention is to avoid and alleviate the problems of the prior art and provide an $\alpha$-$Al_2O_3$ layer deposited in a temperature range of 800-1050 °C with a well-defined growth textures (110), (100), (104), (012), and (001), high growth rate, fine grain size and enhanced mechanical properties i.e. improved wear resistence and improved comb crack resistance. The improved properties are important in metal cutting such as in turning and milling.

Normally, in the prior-art the growth rates for (001), (104) and (012) textured $\alpha$-$Al_2O_3$ layers are 0.7-1.2 $\mu$m/h, typically slightly less than 1 $\mu$m/h. Often the commercial $\alpha$-$Al_2O_3$ layers in wear resistant grades are at least 8-10 $\mu$m thick and the $\alpha$-$Al_2O_3$ coating thickness applied in modern grades has a clear trend to be increased. Consequently, for a coated tool comprising an $\alpha$-$Al_2O_3$ layer of about 10 $\mu$m the process time can, according to this invention, be shortened by at least 5 hours, which is economically important. This is important especially for the (001) textured $\alpha$-$Al_2O_3$ considered to exhibit the best wear properties.

It is further an object of the present invention to provide a method to deposit $\alpha$-$Al_2O_3$ layer with controlled (110), (100), (104), (012), and (001) textures.

DESCRIPTION OF THE INVENTION

The present invention provides a method to control deposition of $\alpha$-$Al_2O_3$ so that the growth textures (110), (100), (104), (012), and (001) can be achieved by controlling the ratio of only two important process variables, namely the $H_2S$ and $CO_2$. This surprising observation holds in a wide temperature range from about 600 to about 1050°C. The invention allows deposition of all above mentioned textures using a wider process window as far as the $H_2S/CO_2$ ratio is kept in the limits disclosed in this application. This, in turn allows higher growth rates, well-controlled smaller grain sizes and thus improved cutting properties and improved crater wear and chipping resistance over the prior-art.

The present inventor has studied the texture development in CVD $\alpha$-$Al_2O_3$, and the observations are described in Figs. 1-4 and below:

The texture development was studied using $H_2S$ concentrations of 0.004-2.2 vol% and $CO_2$ concentrations from about 3.25 to 12 vol% in the temperature range of 600-1050 °C. The $\alpha$-$Al_2O_3$ layers were deposited onto layers comprising $Ti_{1-x}Al_xN$, $Ti_{1-x}Al_xCN$, MT-CVD Ti(C,N) and $TaC_{1-x}N_x$ with a thickness of about 5-10 $\mu$m using the bonding and nucleation procedures disclosed in this application. The correct nucleation and bonding procedures are of crucial importance.

Fig. 1 demonstrates the development of texture coefficients (TC) for (110), (300), (012), (104) and (00 12) determined by XRD and using the Harris formula (presented and explained later in the text) as a function of $H_2S$ concentrations of 0-1.5 at $CO_2$ = 3,25 vol %:

The maximum values for TC(300), TC(012) and TC(104) appeared at about 0.08, 0.16 and 0.32 vol % of $H_2S$, respectively. At $H_2S$ levels exceeding ~ 0.6 vol % a high TC(00 12) started to develop reaching TC(00 12) > 6 at $H_2S$ levels from ~ 0.6 to -1.1 vol%. The total absence of the (00 12) reflection at $H_2S$ < 0.3 vol % should be noted. Further, it should be noted that relatively very low TCs for (110) were detected in all experiments at $CO_2$ = 3.35 vol%. The results also suggest that at the $H_2S$ concentrations exceeding ~ 0.9 vol%, the intensity of (00 12) reflection started to decline with the re-appearance of TC(110). The surprising observation was that the texture of $\alpha$-$Al_2O_3$ is determined by the $H_2S/CO_2$ ratio of the reactive gases in the CVD reactor during deposition of $\alpha$-$Al_2O_3$.

Fig. 2 demonstrates the development of texture coefficients (TC) for (110), (300), (012), (104) and (00 12) determined by XRD and using the Harris formula (presented and explained later in the text) as a function of $H_2S$ concentrations of 0-1.5 at $CO_2$ = 6,25 vol %:

A relatively very high TC(110), was detected at very low concentrations of $H_2S$ ($H_2S$ ~ 0.03 vol %). Further, relatively very high texture coefficients (>5.5) for (300), (110) and (104) reflections at $H_2S$ levels of about 0.08, 0.32 and 0.7 vol %, respectively, could be distinguished. At $H_2S$ concentrations exceeding ~ 1 vol % the TC(00 12) started to dominate. The highest TC (00 12) = 6.3 was obtained at $H_2S$ = 1.2 vol%. It was also noticed that when $H_2S/CO_2$ ratio exceeded 0.4 the TC(00 12) started to decline. A surprising observation was that the texture-regimes of $\alpha$-$Al_2O_3$ are now (at higher $CO_2$ concentration) very clearly separated. It is very clear that this has not been realized in the prior art. It appears that $CO_2$ concentrations exceeding 5-6 vol% should be used for easier control the textures.

It is noted that TC(006) and TC(00 12) behave in similar way and consequently both can be used to evaluate the existence of the (001) texture. Consequently, either TC(006) or TC(00 12) can be used. The use of (006) reflection instead of (00 12) will give identical results.

In an additional experiment the $\alpha$-$Al_2O_3$ layer was deposited without $H_2S$ using a very long deposition time of about 20 hours (due to the low growth rate without $H_2S$). This layer exhibited a (110)-texture being of the order 4.4 as confirmed by XRD using Harris formula as explained later in the text. This observation supports the results presented earlier that TC(110) is combined with low or zero $H_2S$.

As shown in Fig. 3 it is possible to define regimes of the $H_2S/CO_2$ volume ratio (deposition windows) to produce one dominating texture being either (110), (100), (012), (104) or (001). The (100) texture is quantified and confirmed by the TC(300) and the (001) texture is quantified and confirmed by either TC(006) or TC(00 12). It is noted that Fig. 3 uses Miller-Bravais indexing i.e. (hkil), where i = -(h+k), as will be explained later in the text. Some results of the experiments with identified and verified textures (based on 2 repetitions) are depicted on Fig. 3 as a function of $H_2S/CO_2$ (0.004 < $H_2S/CO_2$ < 0.4). $CO_2$ concentrations used in this experiment were from about 3.25 vol % to about 6.50 vol %. As indicated in Fig. 3, (110) texture could only be obtained when $H_2S/CO_2 \leq 0.01$ (field a in Fig. 3) and (100) texture existed when 0.01 < $H_2S/CO_2$ <0.02 (field b in Fig. 3). Thus, to facilitate deposition of (110) and (100) textures very low $H_2S/CO_2$

ratios must be applied. The (110) and (300) reflections were absent at higher $H_2S/CO_2$ values and, instead, TC(012) was found in the experiments when $0.02\leq H_2S/CO_2 <0.1$ (field c, Fig. 3). When $H_2S/CO_2$ exceeded 0.16 - 0.18 the (001) texture [either high TC(006) or TC(00 12)] dominated (field e, Fig. 3). In between the (012) and (001) windows the results suggest the presence of (104) texture (field d, Fig. 3). The process windows for (110), (100) and (104) textures appeared to be narrow as compared with the process windows for (012) and (001) textures. It is emphasized that there are naturally no abrupt boarders separating these process windows (fields a, b, c, d and e) indicated in Fig. 3. As clear from Fig. 3, the $H_2S/CO_2$ ratio is an important parameter, which can be used to control the texture of $\alpha$-$Al_2O_3$. Even though in this connection the effect of $H_2S$ concentration was evaluated at constant $CO_2$ levels it should be noted that based on the present results is straightforward to conclude that the $H_2S/CO_2$ ratio can also be changed by varying the $CO_2$ concentration at a constant $H_2S$ level. *In* the preferred embodiments more precise limits for the $H_2S/CO_2$ ratios will be given.

The growth rates of $\alpha$-$Al_2O_3$ are presented in Fig. 4 (texture was not analysed) as a function of $H_2S$ content at $CO_2$ levels of 3 vol %, 4 vol % and 6 vol %. As shown in Fig. 4, the growth rate of $\alpha$-$Al_2O_3$ was strongly dependent on $H_2S$ and $CO_2$ concentrations and the effect of $H_2S$ was more pronounced at higher $CO_2$ levels. Consequently, at higher $CO_2$ levels relatively very high growth rates could be reached at increased levels of $H_2S$ doping. This has been known by persons skilled in the art. Understanding that the $H_2S/CO_2$ ratio determines the process windows for different textures (the fact that had not been understood earlier) a person skilled in the art, can now select very high growth rates with pre-determined textures.

According to this invention (110), (100), (012), (104) and (001) textured $\alpha$-$Al_2O_3$ coatings can be deposited by chemical vapour deposition (CVD) from the reaction gas comprising 6-10 vol%, preferably 6-8 vol% $CO_2$, 1-4.5 vol%, preferably 1,1-2,2 vol% $AlCl_3$ and 0.01-2.2 vol% $H_2S$, 5-35 vol%, preferably 10-35 vol% $N_2$, 0.5-1.5 vol % HCl, balance $H_2$. Optional additions of 5-15 vol% of CO and 5-15 vol % Ar can be used but are not necessary to obtain the results. The $H_2S/CO_2$ ratio defines the deposition windows to deposit the chosen texture and, as shown in Figs. 1-3 and in the Examples, this invention discloses well-defined process windows for (110), (001), (012), (104) and (100) textures, respectively. Knowing these limits (keeping the $H_2S/CO_2$ ratio inside the defined deposition window) the other process parameters can be adjusted in a very wide range to achieve and optimize the coating properties, such as growth rate and grain size, as far as the said $H_2S/CO_2$ ratio is kept in the experimentally verified limits according to this invention. It is noted that the CO and Ar are not needed during deposition of $\alpha$-$Al_2O_3$ but can be added and a person skilled in the art can do this without disturbing the idea of this invention. The other dopants, such as $SO_2$, HF, $SF_6$ etc. mentioned in the prior art should not be used since they would disturb the growth of the $\alpha$-$Al_2O_3$ layer. It is further noted that $N_2$ must be present during the deposition of $\alpha$-$Al_2O_3$ according to this invention. The deposition is made in a pressure range of 75-800 mbar. The pressure can be adjusted individually for different textures and growth rates. As mentioned above the texture control can be performed in a wide temperature range of 600-1050 °C. However, the lower temperatures 600-800°C, preferably 700-800 °C, most preferably preferably 775-800 °C are preferably used for materials, which exhibit phase transformation when subjected to heat-treatments at higher temperatures, such as cubic $Ti_{1-x}Al_xN$ and cubic $Ti_{1-x}Al_xC_yN_z$.

In the present invention the high temperature region 800-1050 °C, preferably 800-1000 °C, most preferably 900-1000 °C and particularly preferably 950-1000 °C is applied to deposit 5-35 $\mu$m, preferably 8-25 $\mu$m and most preferably 10-15 $\mu$m thick, textured $\alpha$-$Al_2O_3$ layers with enhanced growth rate and fine, columnar grain size onto one more layers of carbide, nitride, carbonitride or oxycarbonitride of one or more of Al, Ti, Ta, Zr, V and Hf, or combinations thereof especially including MT-CVD Ti(C,N) and $TaC_{1-x}N_x$.

HCl is usually added to the process gas to increase coating uniformity (variation in the coating thickness). However, HCl has a minor effect in this respect and it reduces the growth rate of $\alpha$-$Al_2O_3$. For this reason, too high amounts of HCl should be avoided and the volume ratio of $AlCl_3$/HCl should be higher than 1, preferably higher than 1.2 and most preferably higher than 1.5. This is especially important when depositing (001), (104) and (012) textured $\alpha$-$Al_2O_3$ contributing to finer grain size.

It was, also surprisingly, found that $H_2S/CO_2$ ratio is applicable in the pressure range from about 75 to at least 800 mbar. The total pressure affects the ranges of the $H_2S/CO_2$ ratios only slightly. As known, when the total pressure is increased and the percentage of other reactants are kept constant, the supersaturation of Al-donors is relatively constant while the supersaturation of oxygen-donors increases. A strong pressure dependence for the water gas reaction is known to exist. Further, the residence time is increased when the process pressure is increased. It is up to every skilled person in the art to observe these facts and a skilled person can easily find how to adjust the $H_2S/CO_2$ ratios for different pressures. As a rule of thumb for every increment of the total pressure by 25 mbar in the pressure range of 75-800 mbar, the $H_2S/CO_2$ ratio may be increased by 0.001-0.002 depending on the used flow rates (residence time), CVD equipment and hard ware in general (gas distribution system etc.).

The $\alpha$-$Al_2O_3$ layer deposited according to this invention exhibits an X-ray diffraction pattern, as measured using CuKa radiation and theta-2theta scan, with one dominant texture coefficient $4.5< TC(hkl) <7$, selected from the reflections (110), (300), (012), (104), (006) and (00 12). The dominating TC(hkl) being determined by $H_2S/CO_2$ ratio used in the gas mixture and quantified according to Harris formula:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

wherein:

I (h k l) = measured intensity of the (hkl) reflection,
$I_0$ (h k l) = standard intensity of the standard powder diffraction data according to ICDD's JCPDF-card no. 00-042-1468,
n = number of reflections (7) used in the calculation, whereby the (hkl) reflections are:

a) (012), (104), (110), (113), (116), (300) and (00 12) to determine and quantify TC(110), TC(300), TC(012), TC(104) and TC(00 12)
b) (012), (104), (110), (113), (116), (300) and (006) to determine and quantify TC(006).

The terms "texture" or "fibre texture", as used herein, emphasises that the films or layers have not grown having a random orientation. When the films exhibit the fibre texture one set of geometrically equivalent crystallographic planes {hkl} is found to be oriented parallel to the substrate or the film, while there is a rotational degree of freedom of the fibre axis or growth axis, which is perpendicular this plane. The terms "(hkl) texture" or "(hkl) textured" used here thus means a fibre texture with the {hkl} planes being preferentially oriented parallel to the substrate or the film. The quantity of the texture is measured by XRD and Harris formula (see above) is used to obtain TC(hkl). As herein, when 7 reflections are used in measurement, the maximum TC(hkl) is 7, being a measure of a perfect texture. When TC(hkl) = 1 the structure of the coating is random. Usually, the crystallography of hexagonal crystals is described by using Miller-Bravais indices h, k, i and I. We can, as done here (except Fig. 3), omit the $3^{rd}$ index i, which is i = -(h+k). The (001) plane in $\alpha$-$Al_2O_3$ crystal is parallel to (006) and (00 12) planes and the fibre axis [001] is perpendicular to these planes. The (001) texture is in this case quantified by using either (006) or (00 12) reflection (using Harris formula) and using preferably JCPDF-card no. 00-042-1468 or card no.00-010-0173. It is also possible to use (006) XRD reflection only and use JCPDF-card no. 00-046-1212. The XRD (006) reflection, however, is slightly overlapped by a Ti(C,N) reflection but TC(006) can as well be used to quantify (001) texture by using Harris formula. It is further noted that (100) texture) is quantified by using TC(300), also using Harris formula.

The disclosed deposition process of $\alpha$-$Al_2O_3$ comprises thus steps with different $H_2S/CO_2$ ratios in the gas mixture to deposit a layer of $\alpha$-$Al_2O_3$ exhibiting one dominant texture coefficient 4.5<TC(hkl)<7 selected from the reflections (110), (300), (012), (104), (006) and (00 12):

According to one preferred embodiment the (001) textured $\alpha$-$Al_2O_3$ layer with TC(006) >5.5 preferably >6.0 and particularly preferably >6.5 simultaneously exhibiting both TC(110) and TC(100) <0.07, preferably <0.02 and most preferably <0.01 and TC(012) <0.2, preferably <0.1, is deposited with $H_2S/CO_2$ ratio 0.18<$H_2S/CO_2$<0.40 and most preferably 0.22< $H_2S/CO_2$<0.35. Simultaneously together with $H_2S/CO_2$ ratios given above the $CO_2$ concentration should lie between 6-10, preferably 6-8 vol % and most preferably 6.25-7.5 vol %. The coating is deposited at 900-1050 °C, preferably at 950-1050 °C and most preferably 950-1000 °C and in a pressure range of 80-450 mbar, preferably 100-350 mbar, most preferably 120-220 mbar. It is noted that 5-35, preferably 5-10 vol% of $N_2$ is used in the process. The volume ratio of $CO_2/AlCl_3$ should be equal or higher than 4 preferably higher than 4.2. The volume ratio of $AlCl_3/HCl$ should be higher than 1, preferably higher than 1.2 and most preferably 1.5. This kind of process data enhances growth rate and texture and, further, contributes to grain refinement of $\alpha$-$Al_2O_3$. In these circumstances growth rates of about 1.8-3 $\mu$m/h, preferably 2-3 $\mu$m/h can be achieved (*this applies also to all the other textures herein*). It is within the purview of the person skilled in the art to adjust the process parameters to achieve the desired growth rates and optimised texture. The thickness of the said $\alpha$-$Al_2O_3$ is about 5-35 $\mu$m, preferably about 8-25 $\mu$m and most preferably about 10-15 $\mu$m.

The TC(006) being defined as follows:

$$TC(00\ 12) = \frac{I(006)}{I_0(006)} \left[ \frac{1}{n} \sum_{n=1}^{n} \frac{I(hkl)}{I_0(hkl)} \right]^{-1}$$

wherein

(h k l) = measured intensity of the (hkl) reflection
$I_0$ (h k l) = standard intensity of the standard powder diffraction data preferably according to JCPDF-card no. 00-042-1468

n = number of reflections used in the calculation, whereby the (hkl) reflections used are: (012), (104), (110), (006), (113), (116) and (300).

According to one preferred embodiment the (001) textured $\alpha$-$Al_2O_3$ layer with TC(00 12) >5.5 preferably >6.0 and particularly preferably >6.5 simultaneously exhibiting both TC(110) and TC(100) <0.07, preferably <0.02 and most preferably <0.01 and TC(012)<0.2, preferably <0.1 is deposited with $H_2S/CO_2$ ratio 0.18<$H_2S/CO_2$<0.40 and most preferably 0.22< $H_2S/CO_2$<0.35. Simultaneously together with $H_2S/CO_2$ ratios given above the $CO_2$ concentration should lie between 6-10, preferably 6-8 vol % and most preferably 6.25-7.5 vol %. The coating is deposited at 900-1050 °C, preferably at 950-1050 °C and most preferably 950-1000 °C and in a pressure range of 80-450 mbar, preferably 100-350 mbar, most preferably 120-220 mbar. It is noted that 5-35, preferably 5-10 vol% of $N_2$ is used in the process.
The TC(00 12) being defined as follows:

$$TC(00\ 12) = \frac{I(00\ 12)}{I_0(00\ 12)}\left[\frac{1}{n}\sum_{n=1}^{n}\frac{I(hkl)}{I_0(hkl)}\right]^{-1}$$

wherein

(h k l) = measured intensity of the (hkl) reflection
$I_0$ (h k l) = standard intensity of the standard powder diffraction data preferably according to JCPDF-card no. 00-042-1468
n = number of reflections used in the calculation, whereby the (hkl) reflections used are: (012), (104), (110), (113), (116), (300) and (00 12).

In one embodiment either TC(006) or TC(00 12) in (001) textured $\alpha$-$Al_2O_3$ are both higher than 5.0, preferably higher than 5.6 in the same (001) textured $\alpha$-$Al_2O_3$ layer (analysed as described above), the given values corresponding to about 70% and 80% of the maximum obtainable TC(hkl), respectively.
According to another preferred embodiment the (104) textured $\alpha$-$Al_2O_3$ with TC(104) >4.5, preferably >5.0 and most preferably >5.5 and particularly preferably >6, simultaneously having both TC(110) and TC(100) <0.5, preferably <0.3 and most preferably <0.1 is deposited with the $H_2S/CO_2$ ratio of 0.08<$H_2S/CO_2$<0.16, preferably 0.09<$H_2S/CO_2$<0.14 and most preferably 0.095<$H_2S/CO_2$<0.12. Simultaneously together with $H_2S/CO_2$ ratios given above the $CO_2$ concentration should lie between 6-10, preferably 6-8 vol %. The deposition temperature is 900-1050 °C, preferably 950-1000 °C and is carried out in a pressure range of 75-400 mbar, preferably 120-320 mbar and most preferably 120-250 mbar. It is noted that 5-35, preferably 5-10 vol% of $N_2$ is used in the process. The volume ratio of $CO_2/AlCl_3$ ratio should be equal or higher than 4 preferably higher than 4.2. The thickness of the said $\alpha$-$Al_2O_3$ is about 5-35 $\mu$m, preferably about 8-25 $\mu$m and most preferably about 10-15 $\mu$m.
The TC(104) being defined as follows:

$$TC(104) = \frac{I(104)}{I_0(104)}\left[\frac{1}{n}\sum_{n=1}^{n}\frac{I(hkl)}{I_0(hkl)}\right]^{-1}$$

wherein

(h k l) = measured intensity of the (hkl) reflection
$I_0$ (h k l) = standard intensity of the standard powder diffraction data preferably according to JCPDF-card no. 00-042-1468
n = number of reflections used in the calculation, whereby the (hkl) reflections used are: (012), (104), (110), (00 12), (113), (116) and (300).

According to still one preferred embodiment the (012) textured $\alpha$-$Al_2O_3$ with TC(012) >5.5, preferably >6.0 and most preferably >6.5 and simultaneously exhibiting both TC(110) and TC(100) <0.5, preferably <0.3 and most preferably < 0.1 is deposited with the $H_2S/CO_2$ ratio 0.02<$H_2S/CO_2$<0.08, preferably 0.03<$H_2S/CO_2$ <0.06. Simultaneously together with $H_2S/CO_2$ ratios given above the $CO_2$ concentration should lie between 6-10, preferably 6-8 vol %. The deposition temperature is 900-1050 °C, preferably at 950-1000 °C and the process is carried out in a pressure range of 55-500 mbar, preferably 100-300 mbar, most preferably 150-250 mbar. It is noted that 5-35, preferably 5-10 vol% vol% of $N_2$

is used in the process. The thickness of the said $\alpha$-Al$_2$O$_3$ is about 5-35 $\mu$m, preferably about 8-25 $\mu$m and most preferably about 10-15 $\mu$m.

The TC(012) being defined as follows:

$$TC(012) = \frac{I(012)}{I_0(012)} \left[ \frac{1}{n} \sum_{n=1}^{n} \frac{I(hkl)}{I_0(hkl)} \right]^{-1}$$

wherein

(h k l) = measured intensity of the (hkl) reflection
I$_0$ (h k l) = standard intensity of the standard powder diffraction data preferably according to JCPDF-card no. 00-042-1468
n = number of reflections used in the calculation, whereby the (hkl) reflections used are: (012), (104), (110), (00 12), (113), (116) and (300).

In one embodiment a texture coefficient TC(300) >5.0, preferably >5.5 and most preferably >6.0, and simultaneously TC(001) and TC(104) being both less than 0.3, preferably 0.1 and most preferably <0.05. This is obtained using the H$_2$S/CO$_2$ ratio of about 0.01 < H$_2$S/CO$_2$ <0.02. Simultaneously together with H$_2$S/CO$_2$ ratios given above the CO$_2$ concentration should lie between 6-10, preferably 6-8 vol %. Deposition pressure being of the order of 100-450 mbar, preferably 100-350 mbar and most preferably 120-250 mbar. It is noted that 5-35, preferably 5-10 vol% of N$_2$ is used in the process. It should be noticed that the H$_2$S/CO$_2$ ratio should be adjusted for the deposition pressure to be applied, which can be easily done by a person skilled in the art as advised in this disclosure. The thickness of the said $\alpha$-Al$_2$O$_3$ is about 5-35 $\mu$m, preferably about 8-25 $\mu$m and most preferably about 10-15 $\mu$m.

The TC(300) being defined as follows:

$$TC(300) = \frac{I(300)}{I_0(300)} \left[ \frac{1}{n} \sum_{n=1}^{n} \frac{I(hkl)}{I_0(hkl)} \right]^{-1}$$

wherein

(h k l) = measured intensity of the (hkl) reflection
I$_0$ (h k l) = standard intensity of the standard powder diffraction data preferably according to JCPDF-card no. 00-042-1468
n = number of reflections used in the calculation, whereby the (hkl) reflections used are: (012), (104), (110), (113), (116), (300) and (00 12).

In one embodiment a texture coefficient TC(110) > 5, preferably > 5.5 and most preferably > 6.0 and simultaneously TC(001) and TC(104) being both less than 0.3 preferably less than 0.1 and most preferably <0.05. This is obtained using the H$_2$S/CO$_2$ ratio of about H$_2$S/CO$_2$ <0.01, preferably <0.008. Simultaneously together with H$_2$S/CO$_2$ ratios given above the CO$_2$ concentration should lie between 6-10, preferably 6-8 vol %. Deposition pressure being of the order of 100-450 mbar, preferably 100-350 mbar. It is noted that 5-35, preferably 5-10 vol% of N$_2$ is used in the process. It should be noticed that the H$_2$S/CO$_2$ ratio should be adjusted for the deposition pressure to be applied, which can be easily done by a person skilled in the art as advised in this disclosure. The thickness of the said $\alpha$-Al$_2$O$_3$ is about 5-35 $\mu$m, preferably about 8-25 $\mu$m and most preferably about 10-15 $\mu$m.

The TC(110) being defined as follows:

$$TC(110) = \frac{I(110)}{I_0(110)} \left[ \frac{1}{n} \sum_{n=1}^{n} \frac{I(hkl)}{I_0(hkl)} \right]^{-1}$$

wherein

(h k l) = measured intensity of the (hkl) reflection

$I_0$ (h k l) = standard intensity of the standard powder diffraction data preferably according to JCPDF-card no. 00-042-1468

n = number of reflections used in the calculation, whereby the (hkl) reflections used are: (012), (104), (110), (113), (116), (300) and (00 12).

According one preferred embodiment there is thus provided a coated cutting tool insert consisting of a substrate of cemented carbide, cermet, ceramics, steel or a superhard material such as cubic boron nitride (CBN) at least partially coated with a coating with a total thickness of about 15-65 $\mu$m, the coating comprising at least one or more refractory layers of which at least one layer is a fibre-textured $\alpha$-$Al_2O_3$ having a thickness of 5-35 $\mu$m, preferably 8-25 $\mu$m and most preferably 10-15 $\mu$m by chemical vapour deposition (CVD) in the temperature range of 800-1050 °C, preferably 800-1000 °C and most preferably 950-1000 °C on one or more layers comprising carbide, nitride, carbonitride or oxycarbonitride of one or more of Al, Ti, Ta, Zr, V and Hf, or combinations thereof specifically including one or more Ti(C,N) layers obtained by moderate temperature (MTCD) or one or more textured layers of $TaC_{1-x}N_x$ obtained by CVD or combinations of the coatings mentioned. The thickness of Ti(C,N) and $TaC_{1-x}N_x$ should be from 2-25, preferably 5-15 $\mu$m and most preferably 5-10 $\mu$m

In one embodiment the volume ratio of $CO_2/AlCl_3$ should be equal or higher than 4 preferably higher than 4.2. The volume ratio of $AlCl_3/HCl$ should be higher than 1, preferably higher than 1.2. This process data enhances growth rate and texture and, further, contributes to grain refinement of $\alpha$-$Al_2O_3$. When these limitations are applied together with $H_2S/CO_2$ process windows defined for (001), (104), (012), (110) and (100) textured $\alpha$-$Al_2O_3$ finer grain size together with higher growth rates can be achieved. In these circumstances growth rates of about 1.8-3 $\mu$m/h, preferably 2-3 $\mu$m/h can be achieved for (001), (104), (012), (110) and (100) textured $\alpha$-$Al_2O_3$. It is within the purview of the person skilled in the art to adjust the process parameters to achieve the desired growth rates and optimised textures. The thickness of the said $\alpha$-$Al_2O_3$ layers is about 5-35 $\mu$m, preferably about 8-25 $\mu$m and most preferably about 10-15 $\mu$m.

When the growth rate conditions described above are applied the grain refinement of (110), (100), (012), (104) and (001) textured $\alpha$-$Al_2O_3$ layers is clear and, consequently, in one further embodiment of the present invention the inventive textured $\alpha$-$Al_2O_3$ layers are characterized in that the grain width (W) of $\alpha$-$Al_2O_3$ is:

W <0.07 x h, preferably <0.06 x h, wherein

h = $\alpha$-$Al_2O_3$ coating thickness in $\mu$m, and h = 8-25 $\mu$m, preferably 10-15 $\mu$m, W being an average width of 25 consecutive $\alpha$-$Al_2O_3$ crystals of the coating measured by SEM on a polished cross-section along a straight line parallel to the $\alpha$-$Al_2O_3$ coating placed 2 $\mu$m below the coating surface.

It has also surprisingly been noticed that the grain widening in (110), (100), (012), (104) and (001) textured $\alpha$-$Al_2O_3$ grains, when the above explained process parameters are applied (together with bonding layer and oxidation procedures disclosed here), is almost eliminated i.e. the $\alpha$-$Al_2O_3$ crystals in the coating have nearly the same width at top of the coating as well as near the substrate.

Consequently, in one embodiment the coating is (110), (100), (012), (104) or (001) textured $\alpha$-$Al_2O_3$ where $W_{top}/W_{interface}$ <1.4, preferably $W_{top}/W_{interface}$ <1.3 and most preferably $W_{top}/W_{interface}$ < 1.2, where $W_{top}$ is an average width of 25 consecutive $\alpha$-$Al_2O_3$ crystals of the coating measured by SEM on a polished cross-section along a straight line parallel to the coating placed 2 $\mu$m below the coating surface and $W_{interface}$ is an average width of 25 consecutive $\alpha$-$Al_2O_3$ crystals measured by SEM on a polished cross-section along a straight line parallel to the coating placed at a distance of 2 $\mu$m above the interface between the bonding layer and the $\alpha$-$Al_2O_3$ layer. This applies all the inventive textures:(110), (100), (012), (104) and (001).

In one embodiment the inventive $\alpha$-$Al_2O_3$ layers are deposited on $TaC_{1-x}N_x$. The $TaC_{1-x}N_x$ layer is preferably deposited on 0.5-5 $\mu$m, preferably 0.5-2 $\mu$m thick MTCVD Ti(C,N) layer. Usually a thin (0.2-0.5 $\mu$m) layer of TiN is applied first on the cemented carbide substrate. The thickness of the $TaC_{1-x}N_x$ layer is from about 2 to about 25 $\mu$m, preferably 5-15 $\mu$m and most preferably 5-10 $\mu$m and the layer us textured along one of the following crystallographic directions: [111], [220] or [311], preferably [111]. The $TaC_{1-x}N_x$ layers can be obtained using CVD from a mixture comprising 0.2-3.2 vol% $CH_3CN$ or 0.3-2.1 vol % $C_2H_4$ as carbon/nitrogen sources, 0.8-5 vol %, preferably 1.2-3.6 vol % $TaCl_5$, 5-40 vol% $N_2$, balance $H_2$ and Ar in the temperature range of 700-1000 °C, preferably 800-950 °C and in the pressure range of 5 to 500, preferably 5-250 mbar. When using acetonitrile, $CH_3CN$, the texture can be controlled by $TaCl_5/CH_3CN$ ratio together with $TaCl_5/(H_2+N_2)$ and $CH_3CN/(H_2+N_2)$ ratios. In addition, $H_2/N_2$ ration is of importance. It is within the purview of the person skilled in the art to adjust the process parameters to achieve the desired texture/textures. At the deposition temperatures higher than 775°C the $TaC_{1-x}N_x$ layer exhibits stoichiometric coefficients x being 0.3<x<0.7, preferably x is 0.45-0.7 and most preferably 0.48-0.62.

In one embodiment the inventive (110), (100), (012), (104) and (001) textured $\alpha$-$Al_2O_3$ layers according to the invention are deposited on 2 to about 25 $\mu$m, preferably 5-15 $\mu$m and most preferably 5-10 $\mu$m thick CVD $TaC_{1-x}N_x$ layers exhibiting (111), (220) or (311) textures as measured using X-ray diffraction using CuKa radiation and theta-2theta scan. The $TaC_{1-x}N_x$ is characterized by following texture coefficients:

a texture coefficient TC(111) >3.8, preferably >4.2, the texture coefficient being defined as follows:

$$TC(111) = \frac{I(111)}{I_0(111)} \left[ \frac{1}{n} \sum_{n=1}^{n} \frac{I(hkl)}{I_0(hkl)} \right]^{-1}$$

or a texture coefficient TC(220)> 3.5, preferably >4, the texture coefficient being defined as follows:

$$TC(220) = \frac{I(220)}{I_0(220)} \left[ \frac{1}{n} \sum_{n=1}^{n} \frac{I(hkl)}{I_0(hkl)} \right]^{-1}$$

or a texture coefficient TC(311) >3.5, preferably >4, the texture coefficient being defined as follows:

$$TC(311) = \frac{I(311)}{I_0(311)} \left[ \frac{1}{n} \sum_{n=1}^{n} \frac{I(hkl)}{I_0(hkl)} \right]^{-1}$$

wherein:

$I(h\,k\,l)$ = measured intensity of the (hkl) reflection,
$I_0(h\,k\,l)$ = standard intensity of the standard powder diffraction data according to JCPDF-card no. 00-035-0801 or any relevant data.
n = number of reflections (5) used in the calculation, whereby the (hkl) reflections are (111), (200), (220), (311) and (222) and $TC(hkl)_{max}$ is 5.

In one embodiment the inventive the (110), (100), (012), (104) and (001) textured $\alpha$-Al$_2$O$_3$ layers are deposited on a 2-25 $\mu$m, preferably 5-15 $\mu$m and most preferably 5-10 $\mu$m thick Ti(C,N) layers. Usually a thin (0.2-0.5 $\mu$m) layer of TiN is applied first on the cemented carbide substrate. The Ti(C,N) layers are deposited using well-known MT-CVD technique from a gas mixture of 2.2-5.2 vol% TiCl$_4$, 0.4-0.8 vol% CH$_3$CN, 8-22 vol% N$_2$, 1.2 vol % HCl and balance H$_2$ at a temperature of 800-860 $\underline{o}$C. The texture of the MTCVD Ti(C,N) layer can be controlled, for example, by TiCl$_4$/CH$_3$CN volume ratio and H$_2$/N$_2$ volume ratio and a person skilled in the art can easily control the texture of MTCVD Ti(C,N). Preferred textures of Ti(C,N) are (211) and (111). In many cases it has been observed that (211) texture in MTCVD Ti(C,N) layer results in a more pronounced (001) texture in $\alpha$-Al$_2$O$_3$ layers. For this reason, a TiCl$_4$/CH$_3$CN ratio in the reaction gas should be higher than 6, preferably higher than 8, preferably higher than 9.. In the present experiments, the MTCVD layers were controlled to exhibit (211) texture. The texture coefficients were quantified using Harris equation and PDF card No 42-1489. After deposition of MTCVD the temperature was raised to 1000 $\underline{o}$C in H$_2$/N$_2$ atmosphere.

In one embodiment on top of the TaC$_{1-x}$N$_x$ and/or Ti(C,N) layers a 1-2 $\mu$m thich diffusion barrier layer is applied (before depositing bonding and alumina layers) preferably at the same temperature as used to deposit $\alpha$-Al$_2$O$_3$ layer and the bonding layer. The first part of the diffusion barrier layer is a N-rich Ti(N,C) layer deposited at a pressure of 400-600 mbar using 2.2-5.2 vol% TiCl$_4$,1.5-3.8 vol% CH$_4$, 25-50 vol% N$_2$, 1.2 vol % HCl and balance H$_2$ followed by a C-rich Ti(C,N) layer exhibiting a higher carbon content obtained by using same gas mixture but lower deposition pressures of 50-100 mbar, preferably with 20-30 vol% N$_2$ in the reaction gas mixture. The higher carbon content is beneficial for the adhesion between the diffusion barrier layer and the bonding layer. The high-pressure portion of the diffusion barrier layer is about 80% of the total thickness of the diffusion barrier layer. On this layer a bonding layer of (Ti,Al)(C,O,N) is deposited.

In one embodiment a (Ti,Al)(C,O,N) bonding layer of a thickness of 0.1 to 2 $\mu$m is deposited on the diffusion barrier layer from a gas mixture comprising 2.5-15 vol% CO, 0.5-5.5 vol% TiCl$_4$, 0.4-1.2 vol% CH$_3$CN, 0.5-1.5 vol% HCl, 0.5-1.5 vol% AlCl$_3$, 5-35 vol% N$_2$ balance H$_2$ characterized in that 0.4-1.2 vol% CH$_3$CN and 0.5-1.5 vol% AlCl$_3$ are present in the gas mixture during deposition and that the deposition of bonding and oxidation layers are performed at the same temperature as the $\alpha$-Al$_2$O$_3$ layer. The bonding layer is deposited by continuously changing the contents of precursors so that the volume fractions of AlCl$_3$ and CO are increased and volume fractions of CH$_3$CN and HCl are decreased during deposition. The maximum amount of AlCl$_3$ and CO should be reached about 2 min before the end of the process. It is recommended to use a H$_2$ purge (1-2 min) immediately after depositing the (Ti,Al)(C,O,N) layer. After this, before oxidation, the surface of the (Ti,Al)(C,O,N) layer is treated using a mixture of 0.5-3 vol%, preferably 0.5-1 vol% AlCl$_3$, balance H$_2$ for 1-5 min. The bonding layer is then oxidized (to ensure nucleation of $\alpha$-Al$_2$O$_3$) using a gas mixture comprising 0.5-3.2 vol%, preferably 2.8-3.2 vol% CO$_2$, 2.5-20 vol% CO, 5-35 vol% N$_2$ and balance H$_2$. It is

important to use of 4< $CO/CO_2$ <9, preferably the $CO/CO_2$ ratio should be 5-9 during oxidization. The duration of the oxidation step is 2-6 min and it is within the purview person skilled in the art to adjust the process parameters to achieve the desired level of oxidation to result in nucleation of pure $\alpha$-$Al_2O_3$ with good adhesion.

The oxidation step is followed by an additional post-treatment using a mixture of 0.5-7,5 vol% $AlCl_3$, 0.15-1.8 vol% $TiCl_4$, balance $H_2$. The volume ratio of $AlCl_3$/$TiCl_4$ should be higher than 2, preferably 2-5 and most preferably 2-3. The treatment is followed by a $H_2$ purge of 2-4 min. The importance of the $CO/CO_2$ ratio during oxidation and the post-treatments of the oxidized surface has not been realized in the prior art. These treatments ensure nucleation of the alpha phase, especially if lower temperatures are used, and further contributes to finer grain size and enhanced adhesion and texture.

The inventive $\alpha$-$Al_2O_3$ is deposited onto this surface applying $H_2S$ directly on the pre-treated bonding layer. During the first 2-5 min the amount of $H_2S$ can, if found necessary, be 40-60 % of the amount used later in the process. The person skilled in the art can optimize the duration of this step without jeopardizing the adhesion. After this step deposition of $\alpha$-$Al_2O_3$ is performed using a specific $H_2S$/$CO_2$ process windows as defined in this invention to obtain the preferred texture.

Consequently, in one embodiment, $H_2S$ is applied immediately on an oxidized bonding layer after being treated with $AlCl_3$ and/or $TiCl_4$, as described above.

To clarify the process the deposition processes of the $\alpha$-$Al_2O_3$ layers according to this invention are summarized below.

The followings steps are used to deposit alumina layers on MTCVD Ti(C,N):

  a) TiN,
  b) MTCVD Ti(C,N),
  c) Ti(C,N) diffusion barrier layers (high P and low P)
  d) (Ti,Al)(C,O,N) bonding layer
  e) $AlCl_3$ treatment
  f) Oxidation
  g) $AlCl_3$/$TiCl_4$ treatment
  h) Inventive $\alpha$-$Al_2O_3$ layers with given $H_2S$/$CO_2$ deposition windows.

The followings steps are used to deposit alumina layers on $TaC_{1-x}N_x$ :

  a) TiN,
  b) MTCVD Ti(C,N)
  c) $TaC_{1-x}N_x$
  d) Ti(C,N) diffusion barrier layers (high P and low P)
  e) (Ti,Al)(C,O,N) bonding layer
  f) $AlCl_3$ treatment
  g) Oxidation
  h) $AlCl_3$/$TiCl_4$ treatment
  i) Inventive $\alpha$-$Al_2O_3$ layers with given $H_2S$/$CO_2$ deposition windows.

In another preferred embodiment of the coating of the present invention comprises a 2 to 25 $\mu$m, preferably from 5 to 15 $\mu$m and most preferably from 5 to 10 $\mu$m thick layer of Ti(C,N) or $TaC_{1-x}N_x$ between the $\alpha$-$Al_2O_3$ layer and the substrate. Preferably, there is a layer of TiN between MTCVD Ti(C,N) or CVD $TaC_{1-x}N_x$ layers and the substrate, the said TiN layer being deposited directly on the cemented carbide substrate to enhance adhesion. The abbreviation MTCVD used here refers to a well-known technique where Ti(C,N) is deposited employing $TiCl_4$, $CH_3CN$, $N_2$, HCl and $H_2$, in a temperature range of 700-900 $\underline{o}$C, usually 800-880 $\underline{o}$C.

In one embodiment the $TaC_{1-x}N_x$ layer below the inventive (110), (100), (012), (104) or (001) textured $\alpha$-$Al_2O_3$ layers exhibits a stoichiometric coefficient x being 0.3<x<0.7, preferably x is 0.45-0.7 and most preferably 0.48-0.62.

In one embodiment the (110), (100), (012), (104) and (001) textured $\alpha$-$Al_2O_3$ layers according to this invention are above:

- one or more Ti(C,N) layers obtained by moderate temperature (MTCD) exhibiting (211) or (111) texture or
- one or more $TaC_{1-x}N_x$ layers obtained by CVD exhibiting texture coefficients TC(111) >3.8 or TC(220) >3.5 or TC(311)>3.5 and the $TaC_{1-x}N_x$ having stoichiometric coefficients x from 0.3 to 0.7, preferably x is 0.45-0.7 and most preferably x is 0.48-0.62 or
- combinations of these

It has surprisingly been found that $Al_2O_3$ can be obtained at very low temperatures 400-600 °C, preferably 450-500 °C from a gas mixture comprising high percentage of $H_2S$ and $CO_2$ together with high deposition pressure of the order of 400-800 mbar, preferably 600-800 mbar. When the deposition process is carried out under these conditions and applied onto $\alpha$-$Al_2O_3$ layers the coating adopts the crystallography (alpha form) of alumina without any specific bonding nucleation procedures. This low-temperature approach can then be applied to fill the thermal cracks in alumina layers formed during a cooling down period. Such coatings with filled thermal cracks can further be coated by low temperature processes like PVD or wet chemical processes like electroplating.

Consequently, in still one embodiment $\alpha$-$Al_2O_3$ layer is deposited at 400-600 °C onto the inventive (110), (100), (012), (104) or (001) textured $\alpha$-$Al_2O_3$ layers, preferably on (001) textured $\alpha$-$Al_2O_3$ layer, after cooling from a deposition temperature of 950-1000 °C to about 400-500 °C, preferably to about 400-450 °C. Usually at these temperatures the thermal stresses are large enough have caused the coating to crack. When a low-temperature $\alpha$-$Al_2O_3$ is deposited for 10-30 min on top of this layer the cracks will be filled. It is up to a person skilled in the art do define the temperature at which the cracking has occurred. After this a low-T $\alpha$-$Al_2O_3$ process is performed to fill the thermal cracks at about 400-450 °C and from a pressure from about 300 to 800 mbar, the gas mixture comprising 8-12 vol%, preferably 8-10 vol% $CO_2$, 1,6-2.2 vol% $H_2S$, 1,5-4 vol% $AlCl_3$, 5-35 vol%, preferably 5-10 vol% $N_2$, balance $H_2$ with optional addition of of Ar. This coating can then be coated by any coating formed at low temperature by any process including low temperature CVD coating, PVD coating or a wet chemical process like electroplating. The elimination of the thermal cracks increases the chipping resistance of the $\alpha$-$Al_2O_3$ layer.

The absence of the thermal cracks can be detected on top of the alumina layer when examined by OM or SEM, preferably, after polishing or blasting the alumina layer directly or by applying polishing or blasting or any other post treatment to remove any additional layers eventually deposited on the alumina layer to reveal the alumina surface for observation by OM or SEM.

In still one embodiment there is a coating layer atop one of the textured $\alpha$-$Al_2O_3$ layer according to the present invention as a wear indicator or as a layer of other functions, consisting of carbide, nitride, carbonitride or oxycarbonitride of one or more of Ti, Ta, Zr, V and Hf, or combinations thereof, which can be provided using PVD or low temperature CVD or a wet chemical process like electroplating. A TiN layer produced by CVD process using $NH_3$, for example, from a mixture of 0.1-1.9 vol% $TiCl_4$, 0.5-2.5 vol% $NH_3$, balance $H_2$ at a temperature of 400-675 °C is one option or other any other low temperature process. Embodiments, where only parts of the surface areas of the cutting tool insert, preferably the rake face of the cutting tool insert, comprise the $\alpha$-$Al_2O_3$ layer as the uppermost layer whereas the remaining surface areas are covered with the top coating as the outermost layer, can be produced by removing the deposited top coating by blasting or any other well-known method.

In yet another preferred embodiment of the cutting tool insert of the present invention the substrate consists of cemented carbide, preferably of cemented carbide consisting of 4 to 12 wt-% Co, optionally 0.5-10 wt-% cubic carbides of the metals from groups IVb, Vb and VIb of the periodic table, preferably Ti, Nb, Ta or combinations thereof, and balance WC. For steel machining applications the cemented carbide substrate preferably contains 5.5 to 9,0 wt-% cubic carbides of the metals from groups IVb, Vb and VIb of the periodic table, preferably Ti, Nb and Ta, and for cast iron machining applications the cemented carbide substrate preferably contains 0.3 to 3,0 wt-% cubic carbides of the metals from groups IVb, Vb and VIb of the periodic table, preferably Ti, Nb and Ta.

In yet another preferred embodiment the substrate consists of cemented carbide comprising a binder phase enriched surface zone having a thickness of 5 to 30 $\mu$m,10 to 25 $\mu$m.

Preferably, the binder phase enriched surface zone of the cemented carbide body is essentially free from cubic carbides. The binder enriched surface zone enhances toughness of the substrate and widens the application range of the tool. Substrates having a binder enriched surface zone are particularly preferred for cutting tool inserts for metal cutting operations in steel, whereas cutting tool inserts for metal cutting operations in cast iron are preferably produced without binder enriched surface zone.

The present invention further provides a method of manufacturing a cutting tool insert. According one preferred embodiment there is thus provided a method to manufacture a coated cutting tool insert consisting of a substrate of cemented carbide, cermet, ceramics, steel or a superhard material such as cubic boron nitride (CBN) at least partially coated with a coating with a total thickness of about 15-65 $\mu$m, the coating comprising of at least one or more refractory layers of which at least one layer is a fibre-textured $\alpha$-$Al_2O_3$ having a thickness of 5-35 $\mu$m, preferably 8-25 $\mu$m and most preferably 10-15 $\mu$m deposited by chemical vapour deposition (CVD) on one or more layers comprising carbide, nitride, carbonitride or oxycarbonitride of one or more of Al, Ti, Ta, Zr, V and Hf, or combinations thereof especially including one or more Ti(C,N) layers obtained by moderate temperature (MTCD) or one or more textured layers of $TaC_{1-x}N_x$ obtained by CVD or combinations of the coatings mentioned. The thickness of Ti(C,N) and $TaC_{1-x}N_x$ should be from 2-25, preferably 5-15 $\mu$m and most preferably 5-10 $\mu$m. The $\alpha$-$Al_2O_3$ layer is deposited by chemical vapour deposition (CVD) from the reaction gas comprising 6-10 vol%, preferably 6-8 vol% $CO_2$, 1-4.5 vol%, preferably 1.5- 2.2 vol% $AlCl_3$, 0.5-1.5 vol% HCl and 0.01-2.2 vol % $H_2S$, 5-35 $N_2$, preferably 5-10 vol% of $N_2$, balance $H_2$. Optional additions of 0.5-15 vol% CO, and 5-15 vol % Ar can be used but are not necessary to obtain the results. The volume ratio of

$H_2S/CO_2$ in the CVD reaction chamber is used to determine the texture that will be formed in the $\alpha$-$Al_2O_3$ layer. The texture of $\alpha$-$Al_2O_3$ can be controlled by the $H_2S/CO_2$ ratio. Deposition is performed in a temperature range of 800-1050 ºC, preferably 850-1000 °C, and most preferably 950-1000 ºC. The inventive $\alpha$-$Al_2O_3$ layers are applied on MTCVD Ti(C,N) and CVD $TaC_{1-x}N_x$ layers using the bonding and nucleation steps disclosed.

In one embodiment of the method the $CO_2/AlCl_3$ and $AlCl_3/HCl$ ratios are given. The volume ratio of $CO_2/AlCl_3$ ratio should be equal or higher than 4 preferably higher than 4.2. The volume ratio of $AlCl_3/HCl$ should be higher than 1, preferably higher than 1.2 and most preferably higher 1.5. This kind of process data enhances growth rate and texture and, further, contributes to grain refinement of $\alpha$-$Al_2O_3$. Using this process data growth ratess of about 1.8-3 $\mu$m/h, preferably 2-3 $\mu$m/h can be reached. Compared with the typical growth rates of 0.7-1 $\mu$m/h according to the prior art and an alumina layer thickness of 10 $\mu$m the process time can be shortened by more than 5 hours/process. This is economically important.

The method also discloses a (Ti,Al)(C,O,N) the bonding layer, which is crucial to obtain the texture and coating properties and can be applied on all intermediate layers discussed here, the said bonding layer being characterized by higher oxygen and aluminium contents towards the top of the bonding layer (the volume fractions of $AlCl_3$ and CO are increased and volume fractions of $CH_3CN$ and HCl are decreased during deposition). The maximum amount of $AlCl_3$ and CO should be reached about 2 min before the end of the process followed by a special treatment before oxidation. Oxidation is carried out at the same temperature as the $\alpha$-$Al_2O_3$ layer from a gas mixture comprising 0.5-3.2 vol%, preferably 2.8-3.2 vol% $CO_2$, 2.5-20 vol% CO, 5-35 vol% $N_2$ balance $H_2$ with optional additions of Ar. The $CO/CO_2$ volume ratio is from 4 to 9, preferably from 5 to 9 during the oxidation step (duration 2-6 min).

In one embodiment of the method the surface of the (Ti,Al)(C,O,N) bonding layer is treated before oxidation using a mixture of 0.5-3 vol%, preferably 0.5-1 vol% $AlCl_3$, balance $H_2$ for 1-5 min.

In one embodiment of the method the oxidation step is followed by a post-treatment using a mixture of 0.5-7.5 vol% $AlCl_3$, 0.15-1.8 vol% $TiCl_4$, balance $H_2$ using the $AlCl_3/TiCl_4$ volume ratio higher than 2, preferably 2-5 and most preferably 2-3. This treatment ensures nucleation of the alpha phase, especially if lower temperatures are used and further contributes to finer grain size and enhanced adhesion and texture.

In one embodiment of the method a low temperature $\alpha$-$Al_2O_3$ process is performed during cooling from the deposition temperature of about 900-1050 °C to fill the thermal cracks. The process ("low-T-flash") is performed at about 400-450 ° and at a pressure from about 300 to 800 mbar, the gas mixture comprising 8-12 vol%, preferably 8-10 vol% $CO_2$, 1,6-2.2 vol% $H_2S$, 1,5-4 vol% $AlCl_3$, 5-35 vol % $N_2$, balance $H_2$ with optional addition of Ar.

In one embodiment of the method $\alpha$-$Al_2O_3$ process is characterized by the presence of 5-35 vol %, preferably 5-10 vol% of $N_2$.

In one embodiment of the method the growth rate of the inventive $\alpha$-$Al_2O_3$ layers is 1.8-3 $\mu$m/h, preferably 2-3 $\mu$m/h.

DESCRIPTION OF THE DRAWINGS

The present invention is described in more detail in the accompanying drawings, wherein:

Fig. **1** shows one preferred embodiment of the invention, where the TC(hkl) development as function of $H_2S$ at 3.25 vol% $CO_2$ is depicted,
Fig. **2** shows one preferred embodiment of the invention, where the TC(hkl) development as function of $H_2S$ at 6.25 vol% $CO_2$ is depicted,
Fig. **3** shows one more preferred embodiment of the invention, where the regimes of $H_2S/CO_2$ ratios are defined,
Fig. **4** shows still one more embodiment of the invention where the influences of $H_2S$ and $CO_2$ on the growth rate of $\alpha$-$Al_2O_3$ layers are shown,
Figs. **5a** and **b** show LOM (light optical microscope) images of the surfaces of the alumina coatings **a**) according to prior art with thermal cracks and **b**) according to the invention without thermal cracks.
Fig. **6** shows the SEM (scanning electron microscope) cross-section image of 22 $\mu$m thick (104) textured $\alpha$-$Al_2O_3$ layer, deposited in accordance with one embodiment of the invention.

EXAMPLES

In the present examples cemented carbide substrates for cutting inserts with a composition of 6.0 wt% Co and balance WC (hardness about 1600 HV) and cemented carbides containing 5.5 wt% Co and about 8 wt% cubic carbides facilitating a binder enrich zone of about 15-20 $\mu$m were coated. The following insert geometries were used SNUN140408, CNMG120412 and CNMA120408.

Example 1: Invention. MTCVD base layer:

The cemented carbide substrates were coated with coatings comprising the following layers from the surface of the cemented carbide substrate:

a) TiN,
b) MTCVD Ti(C,N),
c) Ti(C,N) diffusion barrier layers (high P and low P)
d) (Ti,Al)(C,O,N) bonding layer
e) $AlCl_3$ treatment
f) Oxidation
g) $AlCl_3/TiCl_4$ treatment.

The process is described in detail below:

a). A thin TiN layer was first deposited onto the cemented carbide substrate from a mixture of 2.2-5,2 vol% $TiCl_4$, 45-55 vol% $N_2$, balance $H_2$ at a temperature of 860 °C and at a pressure of 150-200 mbar.

b). The Ti(C,N) layers are deposited using well-known MT-CVD technique from a gas mixture of 2.2-5.2 vol% $TiCl_4$, 0.44-0.72 vol% $CH_3CN$, 8.5-23.5 vol% $N_2$, 1.2-2.6 vol% HCl and balance $H_2$ at a temperature of 860 ºC to a thickness of 6 $\mu$m. The texture of the MTCVD Ti(C,N) was be controlled by $TiCl_4/CH_3CN$ volume ratio and $H_2/N_2$ volume ratio. The $TiCl_4/CH_3CN$ ratio in the reaction gas was 6-9. Consequently, the MTCVD layers were controlled to exhibit (211) texture. The texture coefficients were quantified using Harris equation and PDF card No 42-1489.

c). After deposition of MTCVD the temperature was raised to 1000 ºC in $H_2/N_2$ atmosphere. At this temperature a 1-2 $\mu$m thich diffusion barrier layer was applied on top of the MTCVD layer using normal high temperature CVD. The first part of the diffusion barrier layer is a N-rich Ti(N,C) layer deposited at a pressure of 520 mbar using 2.2-5.2 vol% $TiCl_4$,1.5-4.8 vol% $CH_4$, 25-50 vol% $N_2$, 1.2 vol% HCl and balance $H_2$ followed by a C-rich Ti(C,N) layer exhibiting a higher carbon content obtained by using same gas mixture but a lower deposition pressure of 50-60 mbar with 20-30 vol% $N_2$ in the reaction gas mixture. The high pressure portion of the diffusion barrier layer Ti(N,C) was about 80% of the total thickness of the diffusion barrier layer. On the Ti(C,N) portion of the diffusion barrier layer a bonding layer of (Ti,Al)(C,O,N) was applied at the same temperature. A $H_2$-purge (2 min) was applied before depositing the bonding layer.

d). The bonding layer of (Ti,Al)(C,O,N) was deposited to a thickness of about 0.6-0.8 $\mu$m from a gas mixture comprising the following precursors ramped linearly from the start to end of the process step (duration 20 min). Start = 0 min, End = 20 min:

- 1.2 vol% CO at 0 min increased linearly to 3.8 vol% at 20 min,
- 3.8 vol% $TiCl_4$ at 0 min increased linearly to 5.2 vol% at 20 min,
- 1.2 vol% HCl at 0 min decreased linearly to 0 vol% at 15 min,
- 0.7 vol% $CH_3CN$ at 0 min decreased linearly to 0 vol% at 15 min (no $CH_3CN$ during the last 5 min),
- 0.5 vol% $AlCl_3$ at 0 min increased linearly to 1.5 vol% at 18 min, 1.8 vol% $AlCl_3$ between 18 min to 20 min.
- 30 vol% $N_2$,
- balance $H_2$.

e). A $H_2$ purge of 2-4 min was applied immediately after deposition, followed by a post-treatment with 0.5 vol% $AlCl_3$, balance $H_2$ for 2 minutes.

f). This surface was then oxidized from a gas mixture comprising 3.1 vol% $CO_2$, 16 vol% CO, 22 vol% $N_2$, balance $H_2$ at a pressure of 40-60 mbar and at 1000 °C. It is important to keep $CO/CO_2$ >5 during this step. The duration of the oxidation step was 4 min.

g). The oxidation step was followed by an additional treatment using a mixture of 1.2 vol% $AlCl_3$ and 0.5 vol% $TiCl_4$, balance $H_2$. This step is necessary to increase nucleation density and ensure the alpha-phase of alumina even at lower temperatures. The treatment was followed by a $H_2$ purge of 2-4 min. These processes were performed at a pressure of about 40-60 mbar and at 1000 °C.

The inventive $\alpha$-Al$_2$O$_3$ layers were deposited onto this surface. It is emphasized that H$_2$S can be applied immediately from the start if the oxidized surface was first treated as described above. Deposition of $\alpha$-Al$_2$O$_3$ was performed to the desired thickness using the specified H$_2$S/CO$_2$ ratios to obtain the preferred texture.

Example 2: Invention, TaC$_{1-x}$N$_x$ base layer:

The cemented carbide substrates were coated with coatings comprising the following layers from the surface of the cemented carbide substrate:

    a) TiN,
    b) MTCVD Ti(C,N)
    c) TaC$_{1-x}$N$_x$
    d) Ti(C,N) diffusion barrier layers (high P and low P)
    e) (Ti,Al)(C,O,N) bonding layer
    f) AlCl$_3$ treatment
    g) Oxidation
    h) AlCl$_3$/TiCl$_4$ treatment

The process is described in detail below:

    a). A thin TiN layer was first deposited onto the cemented carbide substrate from a mixture of 2.2-5,2 vol% TiCl$_4$, 45-55 vol% N$_2$, balance H$_2$ at a temperature of 860 °C and at a pressure of 150-200 mbar.

    b). The Ti(C,N) layers are deposited using well-known MT-CVD technique from a gas mixture of 2.4-5.8 vol% TiCl$_4$, 0.4-0.72 vol% CH$_3$CN, 12.2-23.5 vol% N$_2$, 1.2-2.6 vol% HCl and balance H$_2$ at a temperature of 860 ºC. In this case the MTCVD Ti(C,N) layer was deposited to a thickness of about 1-1.5 $\mu$m including the first TiN layer. The temperature was then increased to 900 °C.

    c). The TaC$_{1-x}$N$_x$ layer was deposited on this MTCVD layer at 900 °C using CVD from a gas mixture comprising 0.7-3.2 vol% CH$_3$CN, 1.2-3.6 vol % TaCl$_5$, 5-40 vol% N$_2$, 5-20 vol% Ar, balance H$_2$ and at a pressure of 150 mbar. The texture was controlled by TaCl$_5$/CH$_3$CN ratio together with TaCl$_5$/(H$_2$+N$_2$) and CH$_3$CN /(H$_2$+N$_2$) ratios to be (111) (220) and (311). The TaC$_{1-x}$N$_x$ layers were deposited to a thickness of 6 $\mu$m.

    d). After deposition of the TaC$_{1-x}$N$_x$ layer the temperature was raised to 1000 ºC in H$_2$/N$_2$ atmosphere. At this temperature a 1-2 $\mu$m thich diffusion barrier layer was applied on top of the TaC$_{1-x}$N$_x$ layer. The first part of the diffusion barrier layer was a N-rich Ti(N,C) layer deposited at a pressure of 520 mbar using 3.8-5.2 vol% TiCl$_4$, 1.5-3.8 vol% CH$_4$, 25-50 vol% N$_2$, 1.2 vol% HCl and balance H$_2$ followed by a C-rich Ti(C,N) layer exhibiting a higher carbon content obtained by using same gas mixture but lower deposition pressures of 50-60 mbar with 20-30 vol% N$_2$ in the reaction gas mixture. The high pressure portion of the diffusion barrier layer Ti(N,C) was about 80% of the total thickness of the diffusion barrier layer.

    e). On the Ti(C,N) portion of the diffusion barrier layer a bonding layer of (Ti,Al)(C,O,N) was applied at the same temperature. A H$_2$-purge of 2 min was applied before depositing the bonding layer. The bonding layer of (Ti,Al)(C,O,N) was deposited to a thickness of about 0.6-1 $\mu$m from a gas mixture comprising the following precursors ramped linearly from the start to end of the process step (duration 20 min). Start = 0 min, End = 20 min:

    - 1.2 vol% CO at 0 min increased linearly to 3.8 vol% at 20 min,
    - 3.8 vol% TiCl$_4$ at 0 min increased linearly to 5.7 vol% at 20 min,
    - 1.2 vol% HCl at 0 min decreased linearly to 0 vol% at 15 min,
    - 0.7 vol% CH$_3$CN at 0 min decreased linearly to 0 vol% at 18 min (no CH$_3$CN during the last 2 min),
    - 0.5 vol% AlCl$_3$ at 0 min increased linearly to 1.5 vol% at 18 min, 1.8 vol% AlCl$_3$ between 18 min to 20 min.
    - 30 vol% N$_2$,
    - balance H$_2$.

    f). A H$_2$ purge of 2-4 min was applied immediately after deposition, followed by a post-treatment with 0.5-1.2 vol% AlCl$_3$, balance H$_2$ for 2-4 minutes.

    g). This surface was then oxidized from a gas mixture comprising 3.15 vol% CO$_2$, 16 vol% CO, 22 vol% N$_2$, balance

$H_2$ at a pressure of 40-60 mbar and at the same temperature as will be used for alumina layer itself. It is important to keep $CO/CO_2$ >5 during this step. The duration of the oxidation step was 4 min.

h). The oxidation step was followed by an additional treatment using a mixture of 0.9 vol% $AlCl_3$ and 0.2 vol% $TiCl_4$, balance $H_2$. This step is necessary to increase nucleation density and ensure the alpha-phase of alumina even at lower temperatures. The treatment was followed by a $H_2$ purge of 2-4 min. These processes were performed at a pressure of about 40-60 mbar.

The inventive $\alpha$-$Al_2O_3$ layers were deposited onto this surface. It is emphasized that $H_2S$ can be applied immediately from the start if the oxidized surface was first treated as described above. Deposition of $\alpha$-$Al_2O_3$ was performed to the desired thickness using the specified $H_2S/CO_2$ ratios to obtain the preferred texture.

Example 3: Reference coatings:

The following 2 reference coatings referred to as 1P and 2P were deposited. The process parameters and details are given in Table 1.
On top of the MTCVD Ti(CN) described above a layer a 1-2 $\mu$m thick bonding layer was deposited at 1000°C according to prior art (EP 3034653 A1) by a process consisting of four separate reaction steps. First a HTCVD Ti(CN) step using $TiCl_4$, $CH_4$, $N_2$, HCl and $H_2$ at 400 mbar, then a second step using $TiCl_4$, $CH_3CN$, CO, $N_2$ and $H_2$ at 70 mbar, then a third step using $TiCl_4$, $CH_3CN$, CO, $N_2$ and $H_2$ at 70 mbar and finally a fourth step using $TiCl_4$, CO, $N_2$ and $H_2$ at 70 mbar. During the third and fourth deposition step some of the gases were continuously changed. Prior to the start of the subsequent $Al_2O_3$ nucleation, the bonding layer was oxidized for 4 minutes in a mixture of 3.7 vol% $CO_2$, 12,5 vol% CO, 30 vol% $N_2$ and balance $H_2$.
Thereafter two $\alpha$-$Al_2O_3$ layers were deposited at 1000 °C and at 55 mbar in two steps. The first step using 1.2 vol-% $AlCl_3$, 4.7 vol-% $CO_2$, 1.8 vol-% HCl and balance $H_2$ was used for both coatings P1 and P2. The step was consequently performed without $H_2S$ and $N_2$. In this experiment duration of this step was 30 min.
Table 1 shows the process data for second step of the alumina coatings P1 and P2. In this experiment the deposition time was 480 min. The total thickness obtained for the alumina coating P1 was 5.8 $\mu$m and for P2 5.1 $\mu$m, consequently the growth rates were 0.73 $\mu$m/h and 0.64 $\mu$m/h, respectively. The TC(00 12) was low (3.8), as should be according the present invention. P2 prior-art layer showed (012) texture, TC(012) =4.1 and TC(104) =2.2. Coating parameters are shown in Table 1 and texture coefficients in Table 2 and 3.

Table 1.

| Coating | Temp °C | P mbar | $CO_2$ [vol%] | $H_2S$ [vol%] | HCl [vol%] | $AlCl_3$ [vol%] | $N_2$ [vol%] | $H_2S/CO_2$ |
|---------|---------|--------|---------------|---------------|------------|-----------------|--------------|-------------|
| P1 | 1000 | 55 | 4.7 | 0.53 | 2.9 | 1.2 | - | 0.12 |
| P2 | 1000 | 55 | 4.7 | 0.34 | 2.8 | 1.2 | - | 0.07 |

Example 4: Invention ($\alpha$-$Al_2O_3$):

In this example $\alpha$-$Al_2O_3$ layers according to this invention with (110), (100), (012), (104) and (001) textures were obtained using the specified $H_2S/CO_2$ ratios and were deposited on top of the MTCVD Ti(C,N) and CVD $TaC_{1-x}N_x$ layers as explained in Examples 1 and 2. The deposition time was 480 min for these alumina layers. The $H_2S/CO_2$ ratios for the Coatings 3-11 were 0.005, 0.01, 0.05, 0.15, 0.16, 0.19, 0.22, 0.22 and 0.24, respectively. Detailed process data for the coatings according to the invention (3-11) and according to prior art (P1 and P2) is given in Table 2. As clear from Table 2, the prior art coatings exhibit low growth rates and cannot produce a strong (001)-texture. It is also clear from Table 2 that a profound (104) texture can be obtained and appears to be very sensitive for the $H_2S/CO_2$ ratio as also clear from Fig. 3.

Table 2.

| Coating | P mbar | $CO_2$ [vol%] | $H_2S$ [vol%] | $AlCl_3$ [vol%] | HCl [vol%] | $N_2$ [vol%] | $H_2S/CO_2$ | TC(hkl) |
|---------|--------|---------------|---------------|-----------------|------------|--------------|-------------|---------|
| P1 | 55 | 4.7 | 0.53 | 1.2 | 2.8 | - | 0.11 | TC(0012) =3.8 |
| P2 | 55 | 4.7 | 0.34 | 1.2 | 2.8 | - | 0.07 | TC(012)=4.1 |
| 3 (invention) | 180 | 6.25 | 0.03 | 1.38 | 1.0 | 5.0 | 0.005 | TC(110)=5.8 |

(continued)

| Coating | P mbar | $CO_2$ [vol%] | $H_2S$ [vol%] | $AlCl_3$ [vol%] | HCl [vol%] | $N_2$ [vol%] | $H_2S/CO_2$ | TC(hkl) |
|---|---|---|---|---|---|---|---|---|
| 4 (invention) | 180 | 6.25 | 0.09 | 1.38 | 1.0 | 5.0 | 0.01 | TC(300)=6,5 |
| 5 (invention) | 75 | 6.25 | 0.32 | 1.38 | 1.0 | 5.0 | 0.05 | TC(012)=5.9 |
| 6 (invention) | 80 | 6.25 | 0.95 | 1.38 | 1.0 | 5.0 | 0.15 | TC(104)=6.4 |
| 7 (invention) | 80 | 6.25 | 0.99 | 1.38 | 1.0 | 5.0 | 0.16 | TC(104)=6.1 |
| 8 (invention) | 120 | 6.25 | 1.20 | 1.38 | 1.0 | 5.0 | 0.19 | TC(00 12) =6.5 |
| 9 (invention) | 180 | 6.25 | 1.38 | 1.38 | 1.0 | 5.0 | 0.22 | TC(006)=6.6 |
| 10 (invention) | 200 | 6.25 | 1.38 | 1.38 | 1.0 | 5.0 | 0.22 | TC(00 12) =6.7 |
| 11 (invention) | 220 | 6.25 | 1.50 | 1.38 | 1.0 | 5.0 | 0.24 | TC(006)=6.7 |

Example 5: Invention (comparative example):

Table 3 shows $H_2S/CO_2$ ratio, TC(hkl), thickness ($\mu$m), growth rate ($\mu$m) and $W_{top}/W_{interface}$ ratio for the coatings according to the invention (3-11) and coatings according to prior art (P1 and P2). It is clear that the inventive coatings can be obtained by predetermined textures, high growth rates and limited widening of the alumina crystals. The grain size measured at h-2 $\mu$m were in all inventive coatings less than 0.07xh $\mu$m.

Table 3.

| Coating | $H_2S/CO_2$ | TC(hkl) | Thickness | Growth rate (um) | $W_{top}/W_{interface}$ |
|---|---|---|---|---|---|
| P1 | 0.11 | TC(0012)=3.8 | 5.8 | 0.72 | 1.8 |
| P2 | 0.07 | TC(012)=4.1 | 5.1 | 0.64 | 1.7 |
| 3 (invention) | 0.005 | TC(110)=5.8 | 9 | 1.8 | 1.39 |
| 4 (invention) | 0.014 | TC(300)=6,5 | 14.2 | 1.8 | 1.37 |
| 5 (invention) | 0.05 | TC(012)=5.9 | 14 | 1.8 | 1.22 |
| 6 (invention) | 0.14 | TC(104)=6.4 | 16 | 2.0 | 1.28 |
| 7 (invention) | 0.16 | TC(104)=6.1 | 21 | 2.6 | 1.27 |
| 8 (invention) | 0.19 | TC(00 12)=6.5 | 17 | 2.1 | 1.25 |
| 9 (invention) | 0.19 | TC(006)=6.6 | 16 | 2.0 | 1.21 |
| 10 (invention) | 0.22 | TC(00 12)=6.7 | 18 | 2.25 | 1.22 |
| 11 (invention) | 0.24 | TC(006)=6.7 | 22 | 2.75 | 1.20 |

Example 6: Invention, alumina layers on Ti(C,N)

In this example layer two alumina layers were deposited using the process of Coating 10 (Tables 2 and 3). The alumina layers were deposited according to the invention onto 6 $\mu$m thick layers of MTCVD Ti(C,N). One of the coatings was cooled down normally from the deposition temperature, referred to as Coating 12a. The other coating, referred to as 12b was subjected to a "alumina flash" during cooling down period: a gas mixture comprising 7.8 vol% $CO_2$, 1.4 $AlCl_3$, and 2.0% $H_2S$, 5 vol% $N_2$ balance $H_2$ was shunted in the reactor for 20 min at a pressure of 620 mbar and in the temperature range of 520-600 °C to close the thermal cracks developed in $\alpha$-$Al_2O_3$. The process data for Coatings 12a and 12b is given in Table 4 together with the process data for the "alumina flash" i.e. low temperature deposition of $\alpha$-$Al_2O_3$ during cooling. The surfaces of the coatings 12a and 12b were studied by optical microscopy after slight polishing and are shown in Figs. 5a and b, respectively. Optical microscopy clearly revealed the absence of thermal cracks on the alumina layer 12b.

Table 4.

| Coating | T [°C] | P [mbar] | $CO_2$ [vol%] | $H_2S$ [vol%] | $AlCl_3$ [vol%] | $N_2$ [vol%] | HCl [vol%] | $H_2$ [vol%] | TC (0012) | $H_2S$/CO ratio |
|---|---|---|---|---|---|---|---|---|---|---|
| 12 a | 1000 | 220 | 6.25 | 1.38 | 1.38 | 5 | 1 | bal | 6.4 | 0.22 |
| Normal cooling | - | - | - | - | - | 20 | - | 80 | - | - |
| 12 b | 1000 | 220 | 6.25 | 1.38 | 1.38 | 5 | 1 | bal | 6.4 | 0.22 |
| Alumina flash 20 min (12b) | 540 | 620 | 8.28 | 2.0 | 1.83 | 5 | 0 | bal | ----- | |

Example 7: Turning test (comparative):

Coatings P1, P2 according to prior art and coatings 5, 7,10 and 11 according to the invention with 10 $\mu$m $\alpha$-$Al_2O_3$ on a base layer according to Example 1 were deposited on WNMG080412 inserts (Table 5). Note the considerably shorter deposition times needed to deposit 10 $\mu$m of alumina according to the invention. The coatings were tested in continuous cutting in steel (CrNiMo6) without coolant using the following cutting parameters:

Geometry: CNMG120408
Cutting speed (Vc) = 220 m/min
Feed (f) = 0,2 mm/rev
Depth of cut ($a_p$) = 2,0 mm.

As clear from Table 5 lifetime of the inventive (104) and (001)-textured coatings were considerably superior to the prior art.

Table 5.

| Coating | TC(hkl) | Process time (h) | Lifetime (min) |
|---|---|---|---|
| P1 | TC(0012) = 3.9 TC(006) = 4.1 | 14 | 12 |
| P2 | TC(012) = 5.6 TC(00 12) = 2.4 | 15 | 8 |
| 5 (invention) | TC(012) = 6.4 | 5.6 | 14 |
| 7 (invention) | TC(104) = 6.5 | 3.9 | 21 |
| 10 (invention) | TC(006) = 6.7 TC(0012) = 6.3 | 4.4 | 22 |
| 11 (invention) | TC(006) = 6.7 TC(0012) = 6.4 | 3.7 | 23 |

Example 8: Edge toughness test (comparative):

The prior art coatings (P1 and P2 with $\alpha$-$Al_2O_3$ thickness of 10 $\mu$m) and Coating 10 with $\alpha$-$Al_2O_3$ thickness of 10 $\mu$m (details in Tables 2 and 3) were deposited according to the invention onto 6 $\mu$m thick layers of MTCVD Ti(C,N), (111)-textured $TaC_{1-x}N_x$, (220)-textured $TaC_{1-x}N_x$ and (311)-textured $TaC_{1-x}N_x$. The coatings tested with respect to edge toughness (chipping resistance) in longitudinal turning of cast iron (SS0130) using the following cutting parameters:

Insert geometry: CNMG120412
Work piece: Cylindrical bar
Cutting speed: $v_c$ = 380 m/min
Feed (f) = 0,4 mm/rev

Depth of cut: $a_p$ = 2,0 mm

The inserts were inspected after 2 and 8 minutes of cutting. As shown in Table 6, compared to the prior art, the edge toughness was considerably enhanced when the coating was produced according to this invention. $TaC_{1-x}N_x$ layer - when present - clearly improved the edge toughness of the coatings.

Table 6.

| Coating | Layer underneath | Flaking of the edge line (%) after 4 minutes | Flaking of the edge line (%) after 8 minutes |
|---|---|---|---|
| P1 (prior art) | Ti(C,N) | 8 | 20 |
| P2 (prior art) | Ti(C,N) | 8 | 22 |
| 10 (invention) | Ti(C,N) | 4 | 14 |
| 10 (invention) | (111) $TaC_{1-x}N_x$ | 0 | 8 |
| 10 (invention) | (220) $TaC_{1-x}N_x$ | 2 | 14 |
| 10(invention) | (311) $TaC_{1-x}N_x$ | 4 | 10 |

Example 9 -SEM of (104) textured coating

Figure 6 shows a (104) textured coating deposited according to data given in Table 3 (Coating 7). The coating thickness is about 21 $\mu$m showing the coating being composed of very columnar grains without considerable widening of the grains towards top of the alumina layer.

Example 10: Comparison of $TaC_{1-x}N_x$ textures

In this example $\alpha$-$Al_2O_3$ layers according the invention (Coating 11, Table 2) were deposited on (111)-textured $TaC_{1-x}N_x$, (220)-textured $TaC_{1-x}N_x$ and (311)-textured $TaC_{1-x}N_x$ coated layers were first studied by XRD to determine the texture coefficients and then tested in longitudinal turning in ball bearing steel (100CrMo7-3) with following data:

Insert geometry: CNMG120412
Cutting speed: $v_c$ = 300 m/min
Feed (f) = 0,30 mm/rev
Depth of cut: $a_p$ = 2,5 mm

As clear from Table 7 the texture of the underlying $TaC_{1-x}N_x$ affects the properties of the alumina coatings.

Table 7.

| Coating | TC(hkl) | Lifetime (min) |
|---|---|---|
| (111) textured $TaC_{1-x}N_x$ | (111) = 4.25 | 14 |
| (220) textured $TaC_{1-x}N_x$ | (220) =3.55 | 8 |
| (311) textured $TaC_{1-x}N_x$ | (311) =3.6 | 8 |

Those skilled in the art will appreciate that numerous changes and modification can be made to the preferred embodiments without departing from the spirit of the invention. It is, therefore, to be understood that the invention is not limited to the disclosed exemplary embodiments; on the contrary, it is intended to cover various modifications and equivalent arrangements within the append claims.

**Claims**

1. A coated cutting tool consisting of a substrate of cemented carbide, cermet, ceramics, steel or a superhard material such as cubic boron nitride (CBN) at least partially coated with a coating consisting of at least one layer of 5-35 $\mu$m thick $\alpha$-$Al_2O_3$ deposited by chemical vapour deposition (CVD) above one or more layers of Ti(C,N) or one or more layers of $TaC_{1-x}N_x$ or combinations thereof wherein the $\alpha$-$Al_2O_3$ exhibits an X-ray diffraction pattern, as measured using $CuK_\alpha$ radiation and theta-2theta scan, and texture coefficients TC(hkl) being determined according to Harris formula,

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

wherein:

I (h k l) = measured intensity of the (hkl) reflection
$I_0$ (h k l) = standard intensity of the standard powder diffraction data according to ICDD's JCPDF-card no. 00-042-1468 or no. 00-010-0173,
n = number of reflections (7) used in the calculation, wherein the (hkl) reflections are either

a): (012), (104), (110), (113), (116), (300) and (00 12) or
b): (012), (104), (006), (110), (113), (116) and (300),

**characterized by**

a texture coefficient TC(110) > 5.0, preferably > 5.5, most preferably >6, simultaneously exhibiting TC(001) and TC(104) <0.3, preferably <0.1 and most preferably <0.05, calculated according to a),
or
a texture coefficient TC(300) >5.0, preferably >5.5, most preferably >6, simultaneously exhibiting TC(001) and TC(104) <0.3, preferably < 0.1 and most preferably <0.05, calculated according to a),
or
a texture coefficient TC(012) >5.0, preferably >5.5, most preferably >6.0 simultaneously exhibiting TC(110) and TC(100) <0.5, preferably <0.3 and most preferably < 0.1 according to a),
or
a texture coefficient TC(104) >4.5, preferably >5, most preferably >5,5 and simultaneously exhibiting TC(110) and TC(100) <0.5, preferably <0.3 and most preferably < 0.1, calculated according to a),
or
a texture coefficient TC(00 12) >5.5, preferably >6.0 and most preferably >6.5, simultaneously exhibiting both TC(110) and TC(100) <0.02, preferably <0.01 and most preferably <0.07and TC(012) <0.2, preferably <0.1 calculated according to a),
or
a texture coefficient TC(006) >5.5, preferably >6.0 and preferably >6.5, simultaneously exhibiting both TC(110) and TC(100) <0.02, preferably <0.01 and most preferably <0.07 and TC(012) <0.2, preferably <0.1, calculated according to b).

2. The coated cutting tool of claim 1 **characterized in that** the grain width (W) of columnar, grains of the said $\alpha$-$Al_2O_3$ grains is:

W<0.07 x h, preferably 0.06 x h wherein,
h = $\alpha$-$Al_2O_3$ coating thickness in $\mu$m, and h = 8-35 $\mu$m, preferably 10-15 $\mu$m, W being an average width of 25 consecutive $\alpha$-$Al_2O_3$ crystals of the coating measured by SEM on a polished cross-section along a straight line parallel to the $\alpha$-$Al_2O_3$ coating placed 2 $\mu$m below the coating surface.

3. The coated cutting tool according to claims 1 and 2 **characterized in that** the ratio $W_{top}$ /$W_{interface}$ of the columnar $\alpha$-$Al_2O_3$ grains is less than 1.4, preferably less than 1.3 and particularly preferably less than 1.2, wherein,
$W_{top}$ is an average width of 25 consecutive $\alpha$-$Al_2O_3$ grains of the coating measured by SEM on a polished cross-section along a straight line parallel to the coating placed 2 $\mu$m below the coating surface and
$W_{interface}$ is an average width of 25 consecutive $\alpha$-$Al_2O_3$ grains measured by SEM on a polished cross-section along a straight line parallel to the coating placed at a distance of 2 $\mu$m above the interface between the bonding layer and the $\alpha$-$Al_2O_3$ layer.

4. The coated cutting according to claims 1-3 **characterized in that** the coating further comprises an intermediate layer of MTCVD Ti(C,N) or CVD $TaC_{1-x}N_x$ between the said $\alpha$-$Al_2O_3$ layer and the substrate having a thickness of from 2 to 20 $\mu$m, preferably, from 5 to 12 $\mu$m, and most preferably from 8 to 10 $\mu$m.

5. The coated cutting tool of claim 4 wherein the $TaC_{1-x}N_x$ layer between the said $\alpha$-$Al_2O_3$ layer and the substrate with stoichiometric coefficients x from 0.3 to 0.7, preferably from 0.45 to 0.7 and most preferably from 0.48 to 0.62 is **characterised by** a texture coefficient
TC(111) >3.8, preferably >4.2 or
TC(220) > 3.5, preferably >4 or
TC(311) >3.5, preferably >4,
the texture coefficient being defined as follows:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

wherein:

I (h k l) = measured intensity of the (hkl) reflection,
$I_0$ (h k l) = standard intensity of the standard powder diffraction data according to JCPDF-card no. 00-035-0801 or any relevant data.
n = number of reflections used in the calculation is 5, whereby the (hkl) reflections are (111), (200), (220), (311) and (222).

6. The coated cutting tool according to any of the previous claims, wherein the coating further comprises a bonding layer of (Ti,Al)(C,O,N) located outermost of the MTCVD Ti(C,N) layer or $TaC_{1-x}N_x$ layer and adjacent to the $\alpha$-$Al_2O_3$ layer **characterized in** the increment of aluminium and oxygen contents towards the top surface.

7. The coated cutting tool according to any of the previous claims **characterized in that** there is a layer atop the $\alpha$-$Al_2O_3$ layer as a wear indicator or as a layer of other functions, consisting of carbide, nitride, carbonitride or oxycarbonitride of one or more of Ti, Zr, V and Hf, or combinations thereof, which can be provided using CVD, PVD or low temperature CVD or a wet chemical process like electroplating.

8. The coated cutting tool of any previous claims **characterized in that** no thermal cracks can be detected in the alumina layer when examined by OM or SEM after polishing or blasting the alumina layer directly or by applying polishing or blasting or any other post treatment to remove any additional layers eventually deposited on the said alumina layer to reveal the alumina surface for observation by OM or SEM.

9. The coated cutting tool of any of the previous claims wherein the substrate consists of cemented carbide or binder enriched cemented carbide, cemented carbide bulk consisting of 4 to 12 wt-% Co, optionally 0.5-10 wt-% cubic carbides of the metals from groups IVb, Vb and VIb of the periodic table, preferably Ti, Nb, Ta or combinations thereof, and balance WC.

10. A method of manufacturing a coated cutting tool insert, preferably according to any of the foregoing claims, comprising the steps of coating a substrate of cemented carbide, cermet, ceramics, steel or cubic boron nitride with a coating of a maximum thickness of 65 $\mu$m consisting one or more refractory layers comprising carbide, nitride, carbonitride or oxycarbonitride of one or more of Al, Ti, Ta, Zr, V and Hf, preferably Ti(C,N) or $TaC_{1-x}N_x$ or combinations thereof and an outer wear resistant layer of textured $\alpha$-$Al_2O_3$ of a thickness of 5-35 $\mu$m deposited by chemical vapour deposition (CVD) in a temperature range of 850-1050 $\underline{o}$C, preferably 900-1000 $\underline{o}$C and most preferably 950-1000 $\underline{o}$C and in a pressure range of 75-800 mbar from the reaction gas mixture comprising 6-10 vol%, preferably 6-8 vol% $CO_2$, 1-4.5 vol%, preferably 1,1-2,2 vol% $AlCl_3$ and 0.01-2.2 vol% $H_2S$, 5-35 vol%, preferably 10-35 vol% $N_2$, 0.5-1.5 vol % HCl, balance $H_2$ with optional additions of 0.5-15 vol% CO, and 5-15 vol % Ar,
**characterized in that**
deposition process comprises the use of specific $H_2S/CO_2$ volume ratios in the gas mixture to achieve a preferred texture coefficient 4.5<TC(hkl)<7 selected from the reflections (110), (300), (012), (104), (006) and (00 12) as follows:

$H_2S/CO_2$ <0.01, preferably $H_2S/CO_2$ <0.008 whereby the said $\alpha$-$Al_2O_3$ layer exhibits TC(110) >5.0 preferably >5.5 and most preferably >6.0 with TC(001) and TC(104) being both simultaneously less than 0.3, preferably less than 0.1 and most preferably less than 0.05,

$0.01 < H_2S/CO_2 < 0.02$, preferably $0.01 < H_2S/CO_2 < 0.015$ whereby the said $\alpha$-$Al_2O_3$ layer exhibits TC(300) >5.0, preferably >5.5 and most preferably >6.0 with TC(001) and TC(104) being both simultaneously less than 0.3, preferably less than 0.1 and most preferably 0.05,

$0.02 < H_2S/CO_2 < 0.08$, preferably $0.03 < H_2S/CO_2 < 0.06$ whereby the said $\alpha$-$Al_2O_3$ layer exhibits TC(012) >5.5, preferably >6.0 and most preferably >6.5 with TC(110) and TC(001) both being simultaneously less than 0.5, preferably less than 0.3 and most preferably less than 0.1,

$0.08 < H_2S/CO_2 < 0.16$, preferably $0.09 < H_2S/CO_2 < 0.14$ and most preferably $0.095 < H_2S/CO_2 < 0.12$ whereby the $\alpha$-$Al_2O_3$ layer exhibits TC(104) higher than 4.5, preferably higher than 5.0 and most preferably higher than 5.5 with TC(110) and TC(100) both being simultaneously less than 0.5, preferably less than 0.3 and most preferably less than 0.1,

$0.18 < H_2S/CO_2 < 0.40$, preferably $0.22 < H_2S/CO_2 < 0.35$ whereby the said $\alpha$-$Al_2O_3$ layer exhibit TC(00 12) or TC(006) higher than 5, preferably higher than 5.5 and most preferably higher than 6.5 with TC(110) and TC(100) being simultaneously less than 0.07, preferably less than 0.02 and most preferably less than 0.01,

The texture coefficients, TC(hkl), being measured by XRD using $CuK_\alpha$ radiation and quantified according to the Harris formula

$$TC(001) = \frac{I(hkl)}{I_0(hkl)}\left[\frac{1}{n}\sum_{n=1}^{n}\frac{I(hkl)}{I_0(hkl)}\right]^{-1}$$

wherein:

I (h k l) = measured intensity of the (hkl) reflection
$I_0$ (h k l) = standard intensity of the standard powder diffraction data according to ICDD's JCPDF-card no. 00-042-1468,
n = number of reflections (7) used in the calculation, wherein the (hkl) reflections are (012), (104), (110), (113), (116), (300) and (00 12) to determine and quantify TC(00 12) or with (012), (104), (110), (113), (116), (300) and (006) to determine and quantify TC(006).

11. The method of claim 10 wherein the said $\alpha$-$Al_2O_3$ layer is deposited applying bonding layer of (Ti,Al)(C,O,N) having a thickness of 0.1 to 2 $\mu$m deposited from a gas mixture comprising 2.5-15 vol% CO, 0.5-5.5 vol% $TiCl_4$, 0.4-1.2 vol% $CH_3CN$, 0.5-1.5 vol% HCl, 0.5-1.5 vol% $AlCl_3$, 5-35 vol%, preferably 20-35 vol% $N_2$, balance $H_2$ **characterized in that** 0.4-1.2 vol% $CH_3CN$, 5-35 vol%, preferably 20-35 vol% $N_2$ and 0.5-1.5 vol% $AlCl_3$ are simultaneously present in the gas mixture during deposition and the volume fractions of $AlCl_3$ and CO in the gas mixture are increased towards the top of the layer.

12. The method of claims 10-11 wherein the oxidation of the surface of said bonding layer being performed from a gas mixture comprising 0.5-3.2 vol%, preferably 2.8-3.2 vol% $CO_2$, 2.5-12 vol% CO, 5-35 vol% $N_2$ balance $H_2$ with optional additions of Ar, **characterized in that** the volume ratio $CO/CO_2$ is from 4 to 9, preferably from 5 to 9 during the oxidation step, the said oxidation step being followed by a post-treatment using a gas mixture comprising 0.5-7.5 vol% $AlCl_3$, 0.15-0.18 vol% $TiCl_4$, balance $H_2$ wherein the $AlCl_3/TiCl_4$ volume ratio is higher than 2, preferably 2-5 and most preferably 2-3.

13. The method according to claims 10-12 wherein, (001) textured $\alpha$-$Al_2O_3$ exhibiting either TC(00 12) or TC(006) >5.5, preferably >6.0 and most preferably >6.5 simultaneously exhibiting TC(110) <0.07, TC(100) <0.07 and TC(012) <0.02 is deposited using 6-10 vol%, preferably 6-8 vol%, most preferably 6.25-7.5 vol% $CO_2$ at a $H_2S/CO_2$ volume ratio of 0.18-0.40, preferably 0.22-0.35 in a pressure range of 80-450 mbar, preferably 100-350 mbar, most preferably 120-220 mbar the said $\alpha$-$Al_2O_3$ exhibiting a growth rate of about 1.8-3 $\mu$m/h, preferably 2-3 $\mu$m/h,
or
(104) textured $\alpha$-$Al_2O_3$ exhibiting a TC(104) >4.5, preferably >5.0 and most preferably > 5 simultaneously exhibiting TC(110) <0.7 and TC(100) <0.7 is deposited using 6-10 vol%, preferably 6-8 vol%, most preferably 6.25-7.5 vol% $CO_2$ and at a $H_2S/CO_2$ volume ratio of $0.08 < H_2S/CO_2 < 0.16$, preferably $0.09 < H_2S/CO_2 < 0.14$ and most preferably $0.095 < H_2S/CO_2 < 0.12$ in a pressure range of 75-400 mbar, preferably 120-320 mbar the said $\alpha$-$Al_2O_3$ exhibiting a growth rate of 1.8-3 $\mu$m/h, preferably 2-3 $\mu$m/h,
or
(012) textured $\alpha$-$Al_2O_3$ exhibiting a TC(012) >5.5, preferably >6.0 and most preferably >6.5, simultaneously exhibiting TC(110) <0.5 and TC(001) <0.5, is deposited using 6-10 vol%, preferably 6-8 vol% $CO_2$ at a $H_2S/CO_2$ volume ratio of 0.02-0.08, preferably 0.03-0.06 in a pressure range of 55-500 mbar, preferably 100-300 mbar and most preferably 150-250 mbar the said $\alpha$-$Al_2O_3$ exhibiting a growth rate of 1.8-3 $\mu$m/h, preferably 2-3 $\mu$m/h.

14. The method of claims 10-13 **characterized in that**, after deposition of the inventive $\alpha$-$Al_2O_3$ with or without a top layer, the CVD reactor is cooled to about 400-500 °C and a new short (10-30 min) deposition cycle of $\alpha$-$Al_2O_3$ is performed directly on the said textured $\alpha$-$Al_2O_3$ or onto a top layer in a temperature range of 400-500 °C wherein the gas mixture comprises more than 6 vol % $CO_2$, preferably 8-12 vol % $CO_2$ and at a pressure of about 300 mbar to about 800 mbar, preferably 400-600 mbar, $H_2S$ being present in amounts of about 0.7-2.2 vol%, preferably 0.6-1.2 vol %.

15. The method of any of claims 10-14 wherein the volume ratio of $AlCl_3$/HCl is higher than 1 preferably higher than 1.2 and most preferably higher 1.5 and simultaneously the volume ratio of $CO_2/AlCl_3$ ratio is equal or higher than 4 preferably higher than 4.2.

Amended claims in accordance with Rule 137(2) EPC.

1. A coated cutting tool consisting of a substrate of cemented carbide, cermet, ceramics, steel or a superhard material such as cubic boron nitride (CBN) at least partially coated with a coating consisting of at least one layer of 8-35 $\mu$m thick $\alpha$-$Al_2O_3$ deposited by chemical vapour deposition (CVD) above one or more refractory layers or combination of these comprising carbide, nitride, carbonitride or oxycarbonitride of one or more of Al, Ti, Ta, Zr, V and Hf, preferably MTCVD Ti(C,N) or $TaC_{1-x}N_x$, wherein the $\alpha$-$Al_2O_3$ being **characterized in that**
the ratio $W_{top}$/$W_{interface}$ of the columnar $\alpha$-$Al_2O_3$ grains is less than 1.4, preferably less than 1.3 and particularly preferably less than 1.2, wherein,
$W_{top}$ is an average width of 25 consecutive $\alpha$-$Al_2O_3$ grains of the coating measured by SEM on a polished cross-section along a straight line parallel to the coating placed 2 $\mu$m below the coating surface and
$W_{interface}$ is an average width of 25 consecutive $\alpha$-$Al_2O_3$ grains measured by SEM on a polished cross-section along a straight line parallel to the coating placed at a distance of 2 $\mu$m above the interface between the bonding layer and the $\alpha$-$Al_2O_3$ layer.

2. The coated cutting tool of claim 1 wherein the grain width (W) of columnar, grains of the said $\alpha$-$Al_2O_3$ grains is:

W<0.07 x h, preferably 0.06 x h wherein,
h = $\alpha$-$Al_2O_3$ coating thickness in $\mu$m, and h = 8-35 $\mu$m, preferably 10-15 $\mu$m, W being an average width of 25 consecutive $\alpha$-$Al_2O_3$ crystals of the coating measured by SEM on a polished cross-section along a straight line parallel to the $\alpha$-$Al_2O_3$ coating placed 2 $\mu$m below the coating surface.

3. The coated cutting tool of claim 1 and 2 wherein $\alpha$-$Al_2O_3$ exhibits an X-ray diffraction pattern, as measured using $CuK_\alpha$ radiation and theta-2theta scan, and texture coefficients TC(hkl) being determined according to Harris formula,

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

wherein:

I(h k l) = measured intensity of the (hkl) reflection $I_0$ (h k l) = standard intensity of the standard powder diffraction data according to ICDD's JCPDF-card no. 00-042-1468 or JCPDF-card no. no. 00-010-0173,
n = number of reflections (7) used in the calculation, wherein the (hkl) reflections are either

a): (012), (104), (110), (113), (116), (300) and (00 12) to determine TC(00 12) or
b): (012), (104), (006), (110), (113), (116) and (300) to determine TC(006),

**characterized in that**

a texture coefficient TC(00 12) >5.5, preferably >6.0 and most preferably >6.5, simultaneously exhibiting both TC(110) and TC(100) <0.02, preferably <0.01 and most preferably <0.07and TC(012) <0.2, preferably <0.1 calculated according to a),

or

a texture coefficient TC(006) >5.5, preferably >6.0 and preferably >6.5, simultaneously exhibiting both TC(110) and TC(100) <0.02, preferably <0.01 and most preferably <0.07 and TC(012) <0.2, preferably <0.1, calculated according to b).

4.  The coated cutting tool of any previous claims **characterized in that** no thermal cracks can be detected on top of the $\alpha$-Al$_2$O$_3$ layer when examined by OM or SEM after polishing or blasting the alumina layer directly or by applying polishing or blasting or any other post treatment to remove any additional layers eventually deposited on the said alumina layer to reveal the alumina surface for observation by OM or SEM.

5.  The coated cutting according to claims 1-4 wherein the coating further comprises an intermediate layer of MTCVD Ti(C,N) or CVD TaC$_{1-x}$N$_x$ or combination of these between the said $\alpha$-Al$_2$O$_3$ layer and the substrate the said coating underlying the $\alpha$-Al$_2$O$_3$ having a thickness of from 2 to 25 $\mu$m, preferably, from 5 to 15 $\mu$m, and most preferably from 5 to 10 $\mu$m.

6.  The coated cutting tool of any of the previous claims wherein the TaC$_{1-x}$N$_x$ layer below the said (001) textured $\alpha$-Al$_2$O$_3$ layer exhibits stoichiometric coefficients x from 0.3 to 0.7, preferably from 0.45 to 0.7 and most preferably from 0.48 to 0.62; the TaC$_{1-x}$N$_x$ layer exhibiting one of the texture coefficients defined below:

    TC(111) >3.8, preferably >4.2 or,
    TC(220) > 3.5, preferably >4 or,
    TC(311) >3.5, preferably >4,

    the texture coefficients being defined as follows:

    $$TC(hkl) = \frac{I(hkl)}{I_0(hkl)} \left[ \frac{1}{n} \sum_{n=1}^{n} \frac{I(hkl)}{I_0(hkl)} \right]^{-1}$$

    wherein:

    I(h k l) = measured intensity of the (hkl) reflection,
    I$_0$(h k l) = standard intensity of the standard powder diffraction data according to JCPDF-card no. 00-035-0801 or any relevant data.
    n = number of reflections used in the calculation is 5, whereby the (hkl) reflections are (111), (200), (220), (311) and (222).

7.  The coated cutting tool according to any of the previous claims, wherein the coating further comprises a bonding layer of (Ti,Al)(C,O,N) located atop the outermost intermediate layer of TaC$_{1-x}$N$_x$ or MTCVD Ti(C,N) adjacent to the $\alpha$-Al$_2$O$_3$ layer, the bonding layer being **characterized by** the increment of aluminium and oxygen contents towards the top surface.

8.  The coated cutting tool according to any of the previous claims **characterized in that** there is a layer on top the $\alpha$-Al$_2$O$_3$ layer as a wear indicator or as a layer of other functions, consisting of carbide, nitride, carbonitride or oxycarbonitride of one or more of Ti, Zr, V and Hf, or combinations thereof, which can be provided using CVD, PVD or low temperature CVD or a wet chemical process like electroplating.

9.  A method of manufacturing a coated cutting tool insert, preferably according to any of the foregoing claims, comprising the steps of coating a substrate of cemented carbide, cermet, ceramics, steel or cubic boron nitride with a coating of a maximum thickness of 65 $\mu$m consisting one or more refractory layers comprising carbide, nitride, carbonitride or oxycarbonitride of one or more of Al, Ti, Ta, Zr, V and Hf, preferably Ti(C,N) or TaC$_{1-x}$N$_x$ or combinations thereof and an outer wear resistant layer of (001)-textured $\alpha$-Al$_2$O$_3$ of a thickness of 8-35 $\mu$m deposited by chemical vapour deposition (CVD) in a temperature range of 850-1050 ºC, preferably 900-1000 ºC and most preferably 950-1000 ºC and in a pressure range of 75-800 mbar from the reaction gas mixture comprising 6-10 vol%, preferably 6-8 vol% CO$_2$, 1-4.5 vol%, preferably 1,1-2,2vol% AlCl$_3$ and 0.01-2.2vol% H$_2$S, 5-35 vol%, preferably 10-35 vol% N$_2$, 0.5-1.5 vol % HCl, balance H$_2$ with optional additions of 0.5-15 vol% CO, and 5-15 vol % Ar,

**characterized in that**

deposition process comprises the use of $H_2S/CO_2$ volume ratio of $0.18<H_2S/CO_2<0.40$, preferably $0.22<H_2S/CC_2<0.35$ in the gas mixture given above to achieve TC(00 12) or TC(006) higher than 5, preferably higher than 5.5 and most preferably higher than 6.5 with TC(110) and TC(100) being simultaneously less than 0.07, preferably less than 0.02 and most preferably less than 0.01, the texture coefficients, TC(hkl), being measured by XRD using $CuK_\alpha$ radiation and quantified according to the Harris formula

$$TC(001) = \frac{I(hkl)}{I_0(hkl)} \left[\frac{1}{n}\sum_{n=1}^{n} \frac{I(hkl)}{I_0(hkl)}\right]^{-1}$$

wherein:

I(h k l) = measured intensity of the (hkl) reflection
$I_0$(h k l) = standard intensity of the standard powder diffraction data according to ICDD's JCPDF-card no. 00-042-1468,
n = number of reflections (7) used in the calculation, wherein the (hkl) reflections are (012), (104), (110), (113), (116), (300) and (00 12) to determine and quantify TC(00 12) or with (012), (104), (110), (113), (116), (300) and (006) to determine and quantify TC(006).

10. The method of claim 9 wherein the said $\alpha$-$Al_2O_3$ layer is deposited applying bonding layer of (Ti,Al)(C,O,N) having a thickness of 0.1 to 2 $\mu$m deposited from a gas mixture comprising 2.5-15 vol% CO, 0.5-5.5 vol% $TiCl_4$, 0.4-1.2 vol% $CH_3CN$, 0.5-1.5 vol% HCl, 0.5-1.5 vol% $AlCl_3$, 5-35 vol%, preferably 20-35 vol% $N_2$, balance $H_2$ **characterized in that** 0.4-1.2 vol% $CH_3CN$, 5-35 vol%, preferably 20-35 vol% $N_2$ and 0.5-1.5 vol% $AlCl_3$ are simultaneously present in the gas mixture during deposition and the volume fractions of $AlCl_3$ and CO in the gas mixture are increased towards the top of the layer.

11. The method of claims 9-10 wherein the oxidation of the surface of said bonding layer being performed from a gas mixture comprising 0.5-3.2 vol%, preferably 2.8-3.2 vol% $CO_2$, 2.5-20 vol% CO, 5-35 vol% $N_2$ balance $H_2$ with optional additions of Ar, **characterized in that** the volume ratio $CO/CO_2$ is from 4 to 9, preferably from 5 to 9 during the oxidation step, the said oxidation step being followed by a post-treatment using a gas mixture comprising 0.5-7.5 vol% $AlCl_3$, 0.15-0.18 vol% $TiCl_4$, balance $H_2$ wherein the $AlCl_3/TiCl_4$ volume ratio is higher than 2, preferably 2-5 and most preferably 2-3.

12. The method preferably according to any of the foregoing claims, wherein (001)-textured $\alpha$-$Al_2O_3$ exhibiting either TC(00 12) or TC(006) >5.5, preferably >6.0 and most preferably >6.5 simultaneously exhibiting TC(110) <0.07, TC(100) <0.07 and TC(012) <0.02 is deposited using 6-10 vol%, preferably 6-8 vol%, most preferably 6.25-7.5 vol% $CO_2$ at a $H_2S/CO_2$ volume ratio of 0.18-0.40, preferably 0.22-0.35 in a pressure range of 80-450 mbar, preferably 100-350 mbar, most preferably 120-220 mbar the said $\alpha$-$Al_2O_3$ exhibiting a growth rate of about 1.8-3 $\mu$m/h, preferably 2-3 $\mu$m/h with grain width (W) of the columnar, grains of the said (001) textured $\alpha$-$Al_2O_3$ grains being:

W<0.07 x h, preferably 0.06 x h wherein,
h = $\alpha$-$Al_2O_3$ coating thickness in $\mu$m, and h = 8-35 $\mu$m, preferably 10-15 $\mu$m, W being an average width of 25 consecutive $\alpha$-$Al_2O_3$ crystals of the coating measured by SEM on a polished cross-section along a straight line parallel to the $\alpha$-$Al_2O_3$ coating placed 2 $\mu$m below the coating surface.

13. The method to deposit $TaC_{1-x}N_x$ layer by CVD preferably according to any of the foregoing claims from a gas mixture comprising 0.2-3.2 vol% $CH_3CN$ or 0.3-2.1 vol % $C_2H_4$ as carbon/nitrogen sources, 0.8-5 vol %, preferably 1.2-3.6 vol % $TaCl_5$, 5-40 vol% $N_2$, balance $H_2$ and Ar in the temperature range of 700-1000 °C, preferably 800-950 °C and in the pressure range of 5 to 500, preferably 5-250 mbar the said $TaC_{1-x}N_x$ layer exhibiting stoichiometric coefficients x from 0.3 to 0.7, preferably from 0.45 to 0.7 and most preferably from 0.48 to 0.62 with the following texture coefficients:

TC(111) >3.8, preferably >4.2 or
TC(220) > 3.5, preferably >4 or
TC(311) >3.5, preferably >4,

the texture coefficient being defined as follows:

$$TC(hkl) = \frac{I(hkl)}{I_0(hkl)}\left[\frac{1}{n}\sum_{n=1}^{n}\frac{I(hkl)}{I_0(hkl)}\right]^{-1}$$

wherein:

I(h k l) = measured intensity of the (hkl) reflection,
$I_0$(h k l) = standard intensity of the standard powder diffraction data according to JCPDF-card no. 00-035-0801 or any relevant data.
n = number of reflections used in the calculation is 5, whereby the (hkl) reflections are (111), (200), (220), (311) and (222).

14. The method of claims 9-13 **characterized in that**, after deposition of the inventive $\alpha$-$Al_2O_3$ with or without a top layer, the CVD reactor is cooled to about 400-500 °C and a new short (10-30 min) deposition cycle of $\alpha$-$Al_2O_3$ is performed directly on the said textured $\alpha$-$Al_2O_3$ or onto a top layer in a temperature range of 400-500 °C wherein the gas mixture comprises more than 6 vol % $CO_2$, preferably 8-12 vol % $CO_2$ and at a pressure of about 300 mbar to about 800 mbar, preferably 400-600 mbar, $H_2S$ being present in amounts of about 0.7-2.2 vol%, preferably 0.6-1.2 vol %.

15. The method of any of claims 9-14 wherein the volume ratio of $AlCl_3$/HCl is higher than 1 preferably higher than 1.2 and most preferably higher 1.5 and simultaneously the volume ratio of $CO_2$/$AlCl_3$ ratio is equal or higher than 4 preferably higher than 4.2.

Europäisches
Patentamt

European
Patent Office

Office européen
des brevets

# EUROPEAN SEARCH REPORT

**Application Number**

EP 20 02 0016

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 570 510 A1 (WALTER AG [DE]) 20 March 2013 (2013-03-20) * paragraphs [0004] - [0013] * * paragraphs [0017] - [0029] * * paragraphs [0033] - [0036]; tables 1-2 * * claims 1-14 * | 1-15 | INV. C23C28/04 C23C16/02 C23C16/12 C23C16/14 C23C16/56 C23C30/00 C23C16/40 |
| X | EP 2 570 511 A1 (WALTER AG [DE]) 20 March 2013 (2013-03-20) * paragraphs [0006], [0018] - [0022] * * paragraphs [0024] - [0026] * * paragraphs [0033] - [0035]; table 1 * * claims 1,3-7,9-15 * | 1-15 | |
| X | EP 3 533 544 A1 (TUNGALOY CORP [JP]) 4 September 2019 (2019-09-04) * paragraphs [0009], [0012] - [0020] * * paragraphs [0025], [0028] - [0035] * * paragraphs [0047] - [0051] * * claims 1-2,5,6,11; tables 6-7,10,13 * | 1-15 | |
| X A | US 2013/045057 A1 (KOJIMA CHIKAKO [JP] ET AL) 21 February 2013 (2013-02-21) * paragraphs [0023] - [0030], [0042] - [0047]; tables 1-2 * * paragraphs [0064] - [0071] * * paragraphs [0089] - [0104] * * claims 1,8; table 14 * | 1,10-12, 14,15 2-9,13 | TECHNICAL FIELDS SEARCHED (IPC) C23C |
| X A | JP 2017 042903 A (SUMITOMO ELECTRIC HARDMETAL CORP) 2 March 2017 (2017-03-02) * paragraphs [0007] - [0014] * * paragraphs [0023] - [0030], [0032] - [0047] * * paragraphs [0061] - [0068]; claims 1-6 * | 1-9 10-15 | |

~~The present search report has been drawn up for all claims~~

| Place of search | Date of completion of the search | Examiner |
|---|---|---|
| The Hague | 31 August 2020 | Ovejero, Elena |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...................................................................
& : member of the same patent family, corresponding document

EPO FORM 1503 03.82 (P04C01)

Europäisches
Patentamt

European
Patent Office

Office européen
des brevets

Application Number

EP 20 02 0016

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-15(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 20 02 0016

The Search Division considers that the present European patent application does not comply with the
requirements of unity of invention and relates to several inventions or groups of inventions, namely:

1. claims: 1-15(partially)

A coated cutting tool consisting of a substrate of cemented carbide, cermet, ceramics, steel or a superhard material such as cubic boron nitride (CBN) at least partially coated with a coating consisting of at least one layer of alpha-Al2 03 deposited by chemical vapour deposition (CVD) above one or more layers of Ti(C,N) or one or more layers of TaC1-x Nx or combinations thereof wherein the alpha alumina exhibits an X-ray diffraction pattern and wherein TC (110) >5 and a method of making it wherein the H2S/CO2 ratio is <0.01

1.1. claims: 1-15(partially)

A coated cutting tool consisting of a substrate of cemented carbide, cermet, ceramics, steel or a superhard material such as cubic boron nitride (CBN) at least partially coated with a coating consisting of at least one layer of alpha-Al2 03 deposited by chemical vapour deposition (CVD) above one or more layers of Ti(C,N) or one or more layers of TaC1-x Nx or combinations thereof wherein the alpha alumina exhibits an X-ray diffraction pattern and wherein TC (0012) >5 OR TC(006) >5 and a method of making it wherein the ratio 0.18< H2S/CO2 <0.40

---

2. claims: 1-15(partially)

A coated cutting tool consisting of a substrate of cemented carbide, cermet, ceramics, steel or a superhard material such as cubic boron nitride (CBN) at least partially coated with a coating consisting of at least one layer of alpha-Al2 03 deposited by chemical vapour deposition (CVD) above one or more layers of Ti(C,N) or one or more layers of TaC1-x Nx or combinations thereof wherein the alpha alumina exhibits an X-ray diffraction pattern and wherein TC (300) >5 and a method of making it wherein 0.01<H2S/CO2 <0.02.

---

3. claims: 1-15(partially)

A coated cutting tool consisting of a substrate of cemented carbide, cermet, ceramics, steel or a superhard material such as cubic boron nitride (CBN) at least partially coated with a coating consisting of at least one layer of alpha-Al2 03 deposited by chemical vapour deposition (CVD) above one or more layers of Ti(C,N) or one or more layers of TaC1-x Nx or combinations thereof wherein the alpha alumina exhibits an X-ray diffraction pattern and wherein TC (012) >5 and a method of making it wherein 0.02<H2S/CO2<0.08

---

page 1 of 2

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

4. claims: 1-15(partially)

A coated cutting tool consisting of a substrate of cemented carbide, cermet, ceramics, steel or a superhard material such as cubic boron nitride (CBN) at least partially coated with a coating consisting of at least one layer of alpha-Al2 03 deposited by chemical vapour deposition (CVD) above one or more layers of Ti(C,N) or one or more layers of TaC1-x Nx or combinations thereof wherein the alpha alumina exhibits an X-ray diffraction pattern and wherein TC (104) >4.5 and a method of making it wherein 0.08< H2S/CO2 < 0.16
---

Please note that all inventions mentioned under item 1, although not necessarily linked by a common inventive concept, could be searched without effort justifying an additional fee.

page 2 of 2

## ANNEX TO THE EUROPEAN SEARCH REPORT
## ON EUROPEAN PATENT APPLICATION NO.

EP 20 02 0016

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2020

| Patent document cited in search report | | Publication date | Patent family member(s) | | Publication date |
|---|---|---|---|---|---|
| EP 2570510 | A1 | 20-03-2013 | EP | 2570510 A1 | 20-03-2013 |
| | | | ES | 2567039 T3 | 19-04-2016 |
| | | | US | 2014173996 A1 | 26-06-2014 |
| | | | WO | 2013037998 A2 | 21-03-2013 |
| EP 2570511 | A1 | 20-03-2013 | CN | 103748265 A | 23-04-2014 |
| | | | EP | 2570511 A1 | 20-03-2013 |
| | | | ES | 2728705 T3 | 28-10-2019 |
| | | | JP | 6162703 B2 | 12-07-2017 |
| | | | JP | 2014526391 A | 06-10-2014 |
| | | | KR | 20140068003 A | 05-06-2014 |
| | | | US | 2014193622 A1 | 10-07-2014 |
| | | | WO | 2013038000 A1 | 21-03-2013 |
| EP 3533544 | A1 | 04-09-2019 | CN | 110023011 A | 16-07-2019 |
| | | | EP | 3533544 A1 | 04-09-2019 |
| | | | JP | WO2018079229 A1 | 04-07-2019 |
| | | | US | 2020038964 A1 | 06-02-2020 |
| | | | WO | 2018079229 A1 | 03-05-2018 |
| US 2013045057 | A1 | 21-02-2013 | CN | 102883841 A | 16-01-2013 |
| | | | EP | 2708300 A1 | 19-03-2014 |
| | | | JP | 5935125 B2 | 15-06-2016 |
| | | | JP | 6379418 B2 | 29-08-2018 |
| | | | JP | 2016026896 A | 18-02-2016 |
| | | | JP | WO2012153438 A1 | 28-07-2014 |
| | | | KR | 20130025381 A | 11-03-2013 |
| | | | US | 2013045057 A1 | 21-02-2013 |
| | | | WO | 2012153438 A1 | 15-11-2012 |
| JP 2017042903 | A | 02-03-2017 | JP | 6519057 B2 | 29-05-2019 |
| | | | JP | 2017042903 A | 02-03-2017 |

EPO FORM P0459

For more details about this annex : see Official Journal of the European Patent Office, No. 12/82

**EP 3 848 485 A1**

**REFERENCES CITED IN THE DESCRIPTION**

**Patent documents cited in the description**

- US 5137774 A
- US 5700569 A
- US 5654035 A
- US 5980988 A
- US 5863640 A
- US 6333103 B
- US 6869668 B
- US 7094447 B
- US 20060199026 A
- US 20060141271 A
- US 7993742 B2
- EP 1953258 B1
- US 2008187774 B2
- US 7763346 B2
- EP 01479 B1
- US 7201956 B
- US 20180274091 A1
- EP 3034653 A1